(19) Europäisches Patentamt
European Patent Office
Office européen des brevets

(11) **EP 4 764 954 A1**

(12) **EUROPEAN PATENT APPLICATION**

(43) Date of publication:
**24.06.2026 Bulletin 2026/26**

(21) Application number: **24307282.4**

(22) Date of filing: **23.12.2024**

(51) International Patent Classification (IPC):
$G06N\ 3/063^{(2023.01)}$     $G06N\ 3/0464^{(2023.01)}$

(52) Cooperative Patent Classification (CPC):
**G06N 3/063; G06N 3/0464; G06V 10/454;
G11C 7/1075**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Institut Mines Telecom
91120 Palaiseau (FR)**

(72) Inventors:
• **CHAUDHURI, Sumanta**
**91190 Gif-Sur-Yvette (FR)**
• **NAVINER, Lirida**
**93150 Le Blanc-Mesnil (FR)**
• **MAZOUZ, Alaa**
**91430 Vauhallan (FR)**

(74) Representative: **Atout PI Laplace
Immeuble Up On
25 Boulevard Romain Rolland
CS 40072
75685 Paris Cedex 14 (FR)**

(54) **A SERIALIZING DEVICE FOR CONVOLUTIONAL FILTERING**

(57)    There is provided a serializer (3) configured to receive an input feature map represented by a Q-dimensional tensor and to convert the received input feature map into a series of 1D vectors, each corresponding to a convolutional patch. The serializer comprises a memory device (300) comprising a plurality of ports and of memory banks adapted to store data words, the ports comprising a least a write port and at least two read ports. The serializer (3) is adapted to perform write operations consisting in writing a number of 1D vectors to a number of banks of said memory device (300) using the writing port, while being adapted for reading in parallel convolutional patches corresponding to stored 1D vectors from banks of the memory device (300) using the at least two reading ports, the extracted convolutional patches being fed to a convolutional filtering device (90) implementing convolutional filters.

**FIGURE 13**

EP 4 764 954 A1

## Description

The invention generally relates to digital Integrated Circuits and, in particular, to a serializing device adapted for convolutional filtering.

## BACKGROUND

Convolutional filtering systems generally use Convolutional Neural Networks (CNNs) that are adapted to perform convolutional filtering.

Convolutional Neural Networks (CNNs) are currently intensively and widely used in many industrial fields. Today, different types of hardware implementations of Convolutional Neural Networks are being used for various on-edge deep learning applications.

In the past decade, tremendous efforts have been directed toward novel problems relating to deep learning, and new breakthroughs were achieved in relation with Deep Learning models. This resulted in more complex and computationally intensive Deep Learning models. However, in terms of hardware implementations, implementations of complex models, such as CNNs, are faced with many technical challenges. These challenges can mostly be attributed to computational efficiency and memory management.

As part of huge endeavors to enhance the performances of CNNs, improved hardware implementations of CNNs are also required to meet the needs for low power, low latency, and easily integrated hardware architectures.

In addition, the development of CNN hardware implementations faces the challenge of deploying CNN models on hardware without a significant decrease in accuracy and precision. Further, in such implementations, the data and parameters cannot be represented using floating point operation, which necessitates relying on suitable solutions to use low-width fixed point representation so as to balance performance with accuracy.

Hardware CNN architectures were proposed to try to address the problems of efficiency and memory management as disclosed for example in:

- Li, H., Yue, X., Wang, Z., Chai, Z., Wang, W., Tomiyama, H. and Meng, L., 2022. Optimizing the deep neural networks by layer-wise refined pruning and the acceleration on FPGA. Computational Intelligence and Neuroscience, 2022;

- Wu Z, Shen C, Van Den Hengel A. Wider or deeper: Revisiting the resnet model for visual recognition. Pattern Recognition. 2019 Jun 1;90:119-33;

- Y.-H. Chen, T. Krishna, J. Emer, and V. Sze, "Eyeriss: An energy efficient reconfigurable accelerator for deep convolutional neural networks," in 2016 IEEE International Solid-State Circuits Conference (ISSCC). IEEE, 2016, pp. 262-263;

- J. Sim, J.-S. Park, M. Kim, D. Bae, Y. Choi, and L.-S. Kim, "14.6 A 1.42 TOPS/W deep convolutional neural network recognition processor for intelligent IoE systems," in 2016 IEEE International Solid-State Circuits Conference (ISSCC). IEEE, 2016, pp. 264-265;

- B. Moons and M. Verhelst, "A 0.3-2.6 TOPS/W precision-scalable processor for real-time large-scale ConvNets," IEEE Symposium on VLSI Circuits, Digest of Technical Papers, vol. 2016-Septe, pp. 1-2, 2016.

- B. Moons, R. Uytterhoeven, W. Dehaene, and M. Verhelst, "14.5 Envision: A 0.26-to-10TOPS/W subwordparallel dynamicvoltage-accuracy-frequency-scalable Convolutional Neural Network processor in 28nm FDSOI," in 2017 IEEE International Solid-State Circuits Conference (ISSCC), 2017, pp. 246-247. [Online]. Available: http://ieeexplore. ieee.org/document/7870353/

- Lu, L., Xie, J., Huang, R., Zhang, J., Lin, W. and Liang, Y., 2019, April. An efficient hardware accelerator for sparse convolutional neural networks on FPGAs. In 2019 IEEE 27th Annual International Symposium on Field-Programmable Custom Computing Machines (FCCM) (pp. 17-25). IEEE.

- Aimar A, Mostafa H, Calabrese E, Rios-Navarro A, Tapiador-Morales R, Lungu IA, Milde MB, Corradi F, Linares-Barranco A, Liu SC, Delbruck T. Nullhop: A flexible convolutional neural network accelerator based on sparse representations of feature maps. IEEE transactions on neural networks and learning systems. 2018 Jul 26;30(3):644-56.

In S. Zhang, Z. Du, L. Zhang, H. Lan, S. Liu, L. Li, Q. Guo, T. Chen, and Y. Chen, "Cambricon-X: An accelerator for sparse neural networks," in Proceedings of the Annual International Symposium on Microarchitecture, MICRO, vol. 2016-Dec. IEEE, oct 2016, pp. 1-12, Tensor Processing Units (TPUs) were proposed. Such TPUs form chips built for efficient deep learning applications, and use Systolic Array Multipliers to handle convolutional computations, Systolic Array Multipliers have been widely used to solve the problem of computational efficiency and perform the high number of operations required within a CNN. In recent years, many edge devices with smaller form factors (low power consumption and limited resources) were released.

Such small-form devices can be split into four categories, namely : Edge ML, Mobile, TinyML, and Offline ML. These devices and platforms are dedicated Artificial Intelligence inference engines.

These dedicated devices correspond to application-specific hardware solutions to the above complex problems associated with CNN hardware implementations. The use of dedicated processing units or tensor cores in these dedicated devices allows users to quickly deploy deep learning models, on edge, with reduced power and cost overheads.

These devices adopt different architectures, depending on a specific target application. The majority of these devices adopt a Systolic Array of Processing Elements approach. However, even if these existing devices address the challenge of implementing deep learning on the edge (i.e. locally, without using a distant server like the cloud), they are not adapted to support a wide range of possible applications and integration. Moreover, their over-reliance on custom-made architectures and blocks restricts their portability and integrability with existing systems.

There is consequently a need for improved hardware architectures for convolutional filtering system that are capable of reducing energy consumption and latency, and improving the computational complexity of the implementation.

## SUMMARY

To address these and other problems, there is provided a serializer. The serializer is configured to receive an input feature map represented by a Q-dimensional tensor and to convert the received input feature map into a series of 1D vectors, each corresponding to a convolutional patch. The serializer comprises a memory device comprising a plurality of ports and of memory banks adapted to store data words, the ports comprising a least a write port and at least two read ports. The serializer is adapted to perform write operations consisting in writing a number of 1D vectors to a number of banks of the memory device using the writing port, while being adapted for reading in parallel convolutional patches corresponding to stored 1D vectors from banks of the memory device using the at least two reading ports, the extracted convolutional patches being fed to a convolutional filtering device implementing convolutional filters.

In some aspects, the serializer may be adapted to implement a number of phases to perform the write operations and the read operations, each phase comprising a write and/or read operation in the ports of the memory device.

In some aspects, the tensor may comprise at least three dimensions $H$, $W$ and $C$, $H$ being the height of the input feature map, $W$ being the width of the input feature map, and $C$ is the number of channels of the input feature map, and a convolutional patch may be defined by a position $< p, q >$ in the tensor $I$ and by two size parameter $f_h$ and $f_w$, a convolutional patch at position $< p, q >$, of size parameters $f_h$ and $f_w$, being defined as:

$$\bigcup_{i\prime=p}^{i\prime=p+f_w} \bigcup_{j\prime=q}^{j\prime=q+f_h} \bigcup_{j\prime=0}^{j\prime=C-1} I[i'][j'][k']$$

Each phase may have a duration of $w \times C \times f_h \times f_w$ clock cycles.

In some embodiments, the memory device may comprise one or more dual port memories.

In one embodiment, the memory device may comprise a plurality of dual port memories, and the memory device may comprise a number of R dual port memories, the memory device having up to $R$ write ports and up to $R$ read ports.

In some embodiments, the serializer may be configured to store N data words, each having W bits, in the memory device.

Each memory bank of the memory device may be only read or written in a given clock cycle.

In some aspects, the elements of the input tensor may be streamed serially to the serializer in a row major order presenting one element of the input tensor at a time to the serializer, according to a row order.

In some embodiments, the elements of the input tensor may be streamed in parallel to the serializer in a column major order presenting a number of elements of the input tensor at a time to the serializer, according to a column order.

In some embodiments, the input feature map may correspond to an image.

Alternatively, the input feature map may correspond to an audio file.

There is further provided a convolutional filtering system comprising a serializer according to any preceding features and a convolutional filtering device implementing convolutional filters, the extracted convolutional patches being fed to the data filtering device, a convolutional filter having dimensions $fh \times fw$, where $f_h$ corresponds to the filter height and $f_w$ corresponds to the filter width.

The convolutional filtering device may comprise one or more layersets, each layerset comprising filter cores, each filter core implementing a number of convolutional filters.

In some aspects, the convolutional filtering system may be for example an accelerator using a convolutional neural network.

The embodiments of the enclosure thereby enable optimizing memory usage and computational efficiency while being particularly adapted to highly resource-constrained environments. They further provide low power, small form, and optimized CNN hardware implementations which are particularly suitable for edge applications of deep learning.

The embodiments of the enclosure further allow for easy integration into existing hardware systems. They also rely on a hardware architecture capable of supporting low-precision and quantization implementations of models to efficiently use the available resources and achieve high performance with low power and small size.

They allow real-time processing and reduced latency and provide an optimized and efficient way to implement convolutional operations on semiconductors.

The embodiments of the disclosure enable alleviating the problems related to memory access and the need to reuse model parameters at run-time efficiently while greatly reducing the number of memory accesses, thereby highly improving performance and enabling computational optimization.

They further enable reducing energy consumption and latency, and more specifically, reducing external memory access (most energy consuming operations), reducing the bit-width for convolution without sacrificing accuracy.

## BRIEF DESCRIPTION OF THE DRAWINGS

The accompanying drawings, which are incorporated in and constitute a part of this specification, illustrate various embodiments of the invention and, together with the general description of the invention given above, and the detailed description of the embodiments given below, serve to explain the embodiments of the invention.

- Figure 1A represents an overview of the CNN accelerator, according to some embodiments; adapted to merge convolutional layers as an example;

- Figure 1B depicts the pipelined processing performed by the L layersets, according to an exemplary implementation;

- Figure 2 represents an exemplary implementation of the layersets, according to some embodiments;

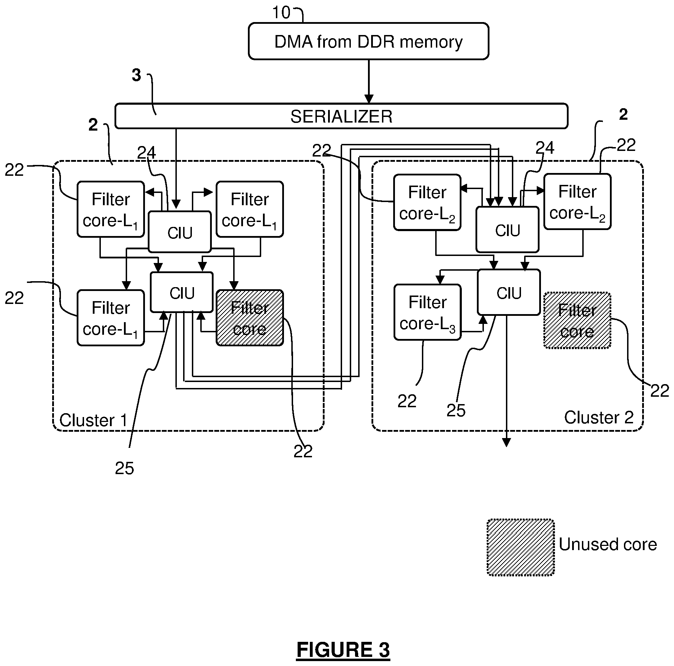

- Figure 3 represents an exemplary implementation of the CNN accelerator, adapted to merge three convolutional layers, according to some embodiments;

- Figure 4 represents the structure of a filter core, according to some embodiments;

- Figure 5 illustrates the 'look-ahead' scheme in embodiments where three convolutional layers are merged into one iteration, according to an exemplary embodiment;

- Figure 6 represents the processing of a convolutional lane, according to an exemplary embodiment where each convolutional lane is configured for 8-bit feature map, and 1, 2, 4 bit weights;

- Figure 7 represents the processing of a convolutional lane according to an exemplary embodiment where each convolutional lane is configured for 8-bit feature map, and bit weights;

- Figure 8 depicts the input and outputs of each filter core;

- Figure 9 depicts the streaming operation corresponding to the presentation of vectors $F_i$ (input feature stream) by a serializer to a filter core and the outputs feature stream obtained at the output of this filter core;

- Figure 10 represents another exemplary implementation of the layersets to merge three convolutional layers of the CNN;

- Figure 11 is a diagram representing an exemplary implementation of accelerator 1 according to the pipelined process illustrated by figure 10;

- Figure 12 depicts the method implemented by the accelerator to determine an output feature map in response to a received input feature map, according to some embodiments;

- Figure 13 represents a convolutional filtering system in which the serializer 3 may be generally used;

- Figure 14 depicts an implementation of the serializer, according to some embodiments;

- Figure 15 represents an exemplary implementation of the memory device of a serializer consisting of a single dual-port memory;

- Figure 16 represents a dual-memory assembly comprising one write port and two read ports;

- Figure 17 depicts a single convolutional patch extraction that may be performed by the serializer from an input feature map, using a single dual-port memory;

- Figure 18 illustrates multiple patch extraction, according to some embodiments;

- Figure 19 is a flow chart depicting the parallel read/write operations performed by the serializer, according to some embodiments;

- Figure 20 illustrates multiple patch extraction, according to embodiments where the input images are streamed in a column major order; and

- Figure 21 depicts the parallel read/write operations performed by the serializer in embodiments using column major operation, according to some embodiments.

## DETAILED DESCRIPTION

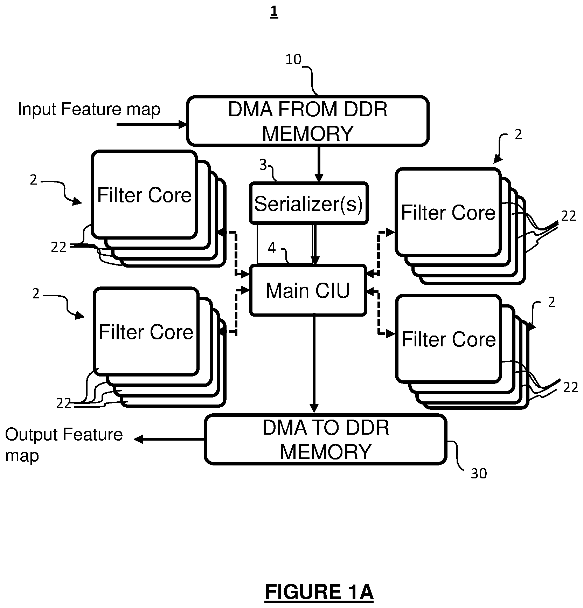

Figure 1A represents an overview of an exemplary convolutional filtering system 1 in which at least one serializer 3 according to some embodiments of the disclosure may be implemented, the convolutional filtering system 1 being adapted to perform convolutional filtering, in response to the receipt of an input feature map,

In the example of figure 1A, the convolutional filtering system is a CNN accelerator 1 that implements a Convolutional Neural Network (CNN) to determine the output feature map in response to a received input feature map.

The CNN accelerator 1 is configured to receive the input feature map and process it to enable a parallel processing of the input feature map by the CNN, without requiring intermediary storing.

To facilitate the understanding of the embodiments of disclosure, some conventional notions related to the operation of a Convolutional Neural Network (CNN) are first defined.

A CNN comprises a set of convolutional layers comprising a set of intermediary layers (e.g. hidden layers) and an output layer. The CNN layers are adapted to learn the patterns of the input data and transform them into a representation that is exploited by the CNN to determine predictions (for example classify an input image).

Each layer of the neural network comprises neurons (artificial neurons, also called neurons). The information received as input by a given neural network layer is processed and passed through the neurons of the layer. Each neuron of a layer is configured to apply a transformation to the received input. The successive transformations performed at the successive convolutional layers produce an output at the output layer.

A neuron in the neural network is characterized by a set of weights representing the strength/amplitude of the connections between the neuron inputs and the neuron (a weight thereby represents the strength/amplitude of the connection between two neurons). Each CNN layer is associated with an activation function introducing non-linearity. A CNN layer uses the set of weights associated with its neurons, biases used to shift the input to the activation function, and its activation function to determine the convolution layer output.

The weight and the biases (generally called the CNN model parameters) may be learnt during the training of the CNN.

During the training of the CNN, the CNN implements one or more epochs, each comprising a forward propagation phase and a backward propagation phase.

The forward propagation phase refers to the process where the input data is passed through the layers of the CNN, using the weights and activation functions to compute the output.

A convolutional layer applies a convolutional operation to received input data corresponding to the input feature map applied to the CNN to filter the information and produce a feature map. The feature map produced by the last layer of the CNN corresponds to the output feature map.

In a forward propagation phase, data flows through the CNN layers of the CNN until arriving to the output layer. During a forward propagation phase, at each CNN layer, the output data of the previous CNN layer is received as the current layer inputs, the weighted sum of the received layer inputs and biases is calculated for each neuron of the current CNN layer using the weights associated with the connections of the neuron, and the activation function associated with the current CNN layer is applied to the weighted sum, which provides the CNN layer output.

In the backward propagation phase, the neural network is configured to calculate the gradients of a loss function (also called cost function), the gradients corresponding to the gradients of the loss with respect to the current network parameters (weight and biaises), and apply a descent gradient algorithm to update the weights and the biases of the neural network model so as to minimize the loss function.

The trained CNN can be then use to make prediction in response to an input feature map, using the learnt model parameters, for example during an inference phase or online in the CNN is an online CNN.

As shown in figure 1A, the CNN accelerator 1 according to the embodiments of the disclosure comprises one or more serializers 3 and $N$ filter cores 22 configured to perform convolution operations in parallel in response to the receipt of a part of the input feature map. The serializer(s) may be connected to the $N$ filter cores 22 using at least one main configurable interconnection unit CIU 4.

For simplification purpose, the following description of some embodiments of the disclosure will be mainly made with reference to an accelerator 1 using one serializer 3.

According to some aspects, the $N$ filter cores 22 of the accelerator 1 may be advantageously organized in L layersets 2, each comprising of one or more cores 22, and each layerset being configured to perform the equivalent computation of a convolutional layer. As used herein, the equivalent computation of a convolutional layer of the CNN refers to the convolutional operation performed by this CNN layer.

The layersets 2 are interconnected in a pipelined fashion. Each layerset 2 therefore corresponds to a set of filter cores 22 and uses the outputs delivered by its filter cores to perform the equivalent computation of a CNN convolutional layer. Each layer set 2 corresponds to a pipeline stage. The layersets 2 may be interconnected in a pipelined fashion using auxiliary Configurable Interconnection Units, CIUs, (not shown in figure 1A), also called layerset CIUs.

In some embodiments, the L layersets 2 may be mapped to c hardware clusters 2 (in the example of figure 1A, c = 4) comprising at least two clusters. In some embodiments, one or more layersets 2 may be implemented inside a single hardware cluster. Alternatively, a hardware cluster may be used to implement two or more layersets.

A cluster may be therefore used to perform the equivalent computation of one or more convolutional layers of the CNN.

The following description of some embodiments will be made mainly with reference to an implementation of the L layersets in the form of c clusters for illustration purpose only, although the skilled person will readily understand that the disclosure is not limited to such implementation of the layersets.

The input feature map refers to the initial data structure that is processed by the CNN accelerator to generate multiple output feature maps.

The input feature map and the output feature map may be represented by a Q-dimensional tensor, Q being an integer number at least equal to 1. The Q-dimensional tensor representing the input feature map will be denoted $I$.

For example, the input feature map may correspond to at least one input image. In this case, the input feature map be represented by a 4-Dimensional (Q-D) tensor $I$ (Q = 4) of dimensions $< N, H, W, C >$ (the tensor $I$ is also denoted $I<N, H, W, C>$), where $N$ is the numbers of images, $H$ denoting the height of the input image, $W$ denoting the width of the input image, and C denoting the number of features or channels. Alternatively, if the input feature map corresponds to only one input image, the input feature map may be represented by a 3-D tensor $I$ (Q = 3) of dimension $< H, W, C >$ (also denoted by $I < H, W, C >$) with $H$ denoting the height of the input image, $W$ denoting the width of the input image, and C denoting the number of features or channels. For example, the input feature map may be a color image RGB (Red, Green, Blue), with the parameter C being equal to 3 (C = 3).

Although the description of embodiments of the disclosure will be made essentially with reference to an input feature map of image type (case of an input feature map corresponding to one image) represented by a tensor $< H, W, C >$, the skilled person will readily understand that the embodiments of the disclosure are not limited to such type of input feature map and encompasses any input feature map on which convolutional filtering may be applied, such as for example an audio input feature map.

A serializer 3 (also called 'serialization device') is configured to serialize the input feature map represented by a Q-D tensor $I$ into a set of serialized vectors, each corresponding to a convolutional patch comprising elements of the input feature map.

A convolutional patch thereby corresponds to a subset of the Q-D tensor $I < H, W, C >$, denoted $CP < f_h, f_w, C >$, corresponding to a region in $I$ of width $f_w$, height $f_h$, and comprising $C$ channels.

The input feature map be received by the serializer 3 from an input memory 10, which may be for example a Double Data Rate (DDR) memory accessed through a Direct Memory Access (DMA) such as an AXI (AMBA eXtensible Interface) DMA.

The output feature map be delivered by the CNN accelerator 1 to an output memory 30, which may be for example a DDR memory accessed through a Direct Memory Access (DMA), such as for example an AXI DMA.

The serializer 3 (also called 'serializer') is configured to receive the input feature map $I$ and serialize it (or 'transform' it) into a series of 1D vectors $F_i$, corresponding to convolutional patches, each of size $N_v$ such that $F_i: < f_{i,0}, f_{i,1}, f_{i,2}, ....f_{i,N_{v-1}} >$. $N_v$ is equal to $f_h \times f_w \times C$.

The CNN accelerator 1 may comprise a serialized vector storage memory adapted to store the serialized 1D vectors generated by the serializer 3. In an embodiment, the serialized vector storage memory may be for example and without limitations, a Block RAM (BRAM) in an FPGA implementation of the accelerator 1, a BRAM being suitable to handle large volume of data, or SRAM macros for ASIC implementations.

The input feature maps may be loaded from the input memory 10 and fed into the serializer 3. The serialized 1D vectors may be broadcasted to at least some of layersets 2 that are adapted to operate in parallel. In figure 1A, the accelerator 1 comprises for example and without limitations 16 filter cores 22 organized in 4 layersets (L = 4). All of the cores may or may not be used in a particular configuration.

The serializer 3 may be adapted to convert incoming high dimensional data (corresponding to the input feature map) into a number of serialized 1D vectors suitable for the processing by the layersets 2, while allowing for continuous streaming of input data through the pipeline by pre-buffering incoming stream elements and while the dedicated processing resources are occupied.

In some embodiments, at least some of the layersets 2 may process the serialized vectors determined by the serializer 3 in parallel and the outputs of one or more layersets 2 may be combined to determine the output feature map.

As shown in figure 1A, the main configurable interconnection unit (CIU) 4 is configured to broadcast the serialized vectors to selected layersets 2 to enable parallel processing.

More specifically, the configurable interconnection unit (CIU) 4 may be configured to transmit a serialized vector, corresponding to a convolutional patch, to at least one layerset 2.

A number of layersets 2 of the accelerator 1 may perform in parallel the convolutional operations related to the different layers of the CNN, thereby merging these layers.

The accelerator 1 according to the embodiments of the disclosure enables a look-ahead computational optimization. The "look-ahead" scheme lies on the merging of two or more CNN convolutional layers.

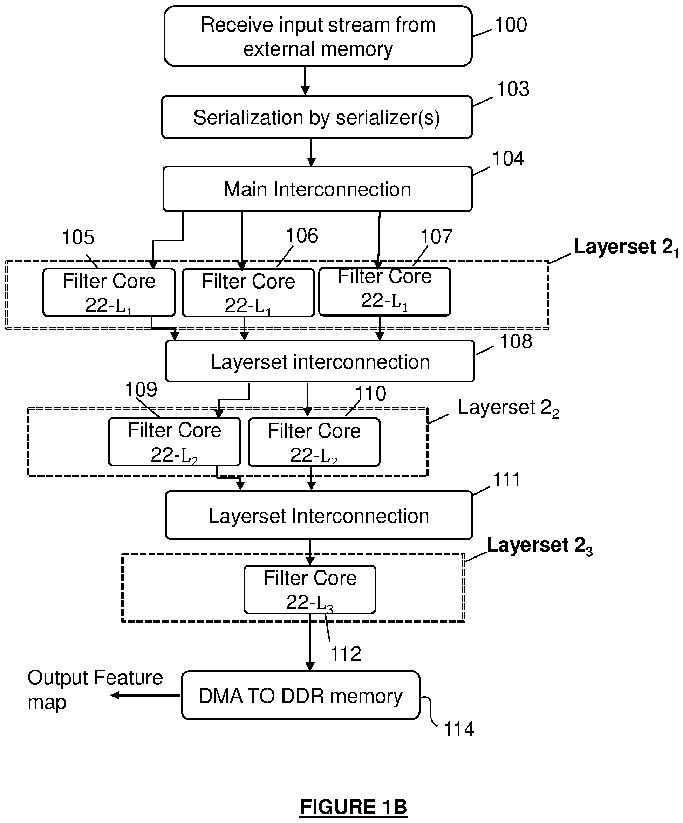

Figure 1B depicts the pipelined processing performed by the L layersets 2 according to an exemplary implementation.

In the example of figure 1B, the N filter cores 22 are organized in $L = 3$ layersets denoted $2_1$, $2_2$, $2_3$, each comprising of one or more filter cores 22 and each being configured to perform the equivalent computation of a convolutional layer (convolutional layer $L_1$ for layerset $2_1$, convolutional layer $L_2$ for layerset $2_2$, convolutional layer $L_3$ for layerset $2_3$).

In this example, the first layerset $2_1$ comprises 3 filter cores 22, the second layerset $2_2$ comprises 2 filter cores 22 and the third layerset $2_3$ comprises a unique filter core 22.

For example, the layersets 2 may be physically implemented with clusters such as the three cores 22 of the first layerset $2_1$ are mapped to a first cluster 'cluster 1', the 2 cores 22 of the layerset $2_2$ are mapped to a second cluster 'cluster 2', and the final core 22 of the layerset $2_3$ is mapped to a third cluster 'cluster 3'.

A given input feature map $I$ may be received in the input memory 10 in block 100 and serialized by the serializer(s) 3 into serialized vectors, in block 103.

In the example of figure 1B, serialized vectors are transmitted by a serializer 3 to the layerset $2_1$, through the main CIU 4, in block 104, each serialized vector corresponding to a convolutional patch, while each layerset $2_1$, $2_2$, and $2_3$ may be configured to perform the convolutional operations related to a given layer of the CNN.

As shown in figure 1B, the three layersets $2_1$, $2_2$, and $2_3$ are interconnected in a pipelined fashion so that when the input stream is being processed by layerset $2_1$ (blocks 105, 106 and 107) the output of layer $2_1$ is being processed in parallel by the next layerset $2_2$ (blocks 109, 110), and the output of layer $2_2$ is being processed in parallel by the next layerset $2_3$ (block 112). The layersets may be interconnected by layerset interconnections at blocks 108, 111 for example using a layerset output CIU 25, at the output of the each layerset 2.

The final layerset $2_3$ delivers an output. The plurality of layerset outputs may be then combined to determine the output feature map that may be sent to the output memory 30, in block 114 (for example through DMA if the output memory is a DDR).

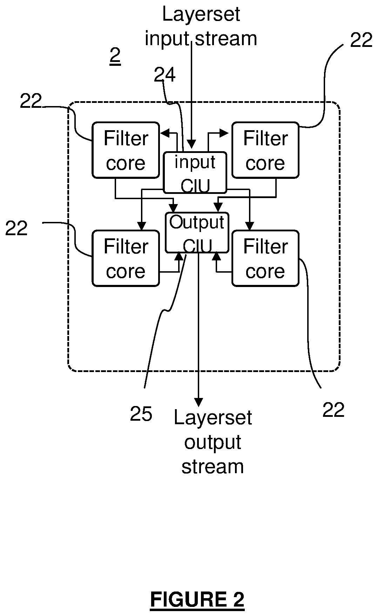

Figure 2 represents an exemplary implementation of layerset 2 in the form of a cluster, according to some embodiments. In such embodiment, each layerset 2 of the accelerator 1 is implemented by a single cluster. Each layerset 2 (and therefore each cluster in this embodiment) comprises a number $n$ of filter cores 22 ($n$ being at least equal to one) adapted to process in parallel a data stream received by the layerset 2. In the example of figure 2, the number of filter cores 22 per layerset is $n = 4$.

The CNN accelerator 1 therefore comprises $n \times L$ filter cores 22 adapted to perform the convolution operations of the CNN while limiting the number of memory accesses.

A given layerset will be also denoted as layerset $2_i$, using index $i$ with $i$ being comprised between 1 and L (the reference 2 will be also used to generally denote the layersets).

Each layerset $2_i$ may use a variable number $n_i$ of filter cores for the processing of a given input feature map received in the input memory 10. Therefore, the number $n_i$ of filter cores 22 used by a layerset 2 in response to the receipt of given input feature map $I$ to be processed by the accelerator 1 may be inferior or equal to $n$ (i.e. $n_i$ is comprised between 1 and $n$).

In each layerset $2_i$, the input feature stream received by the layerset 2 may be sent to at least some of the filter cores 22 of the layerset.

Within each layerset $2_i$, the data are distributed to a number $n_i$ of the filter cores 22.

Each filter core 22 is configured to process the data in parallel across $K$ convolutional lanes.

As shown in figure 2, in some embodiments, each layerset 2 may comprise or be associated with a layerset input CIU 24 (also called 'first layerset CIU' or 'internal broadcasting unit'). A layerset 2 may receive its input from its associated layerset input CIU 24. The layerset input CIU 24 associated with a layerset 2 is configured to broadcast an input stream received by the layerset 2, corresponding to a serialized vector determined by the serializer(s), to at least some of the filter cores 22 of the layerset 2. Each filter core 22 provides a filter output, in a continuous stream.

The data exchanged in the CNN accelerator 1 and in the different layersets 2 may be performed according to a data exchange protocol in the form of a continuous data stream, such as for example and without limitation the protocol AXI (AMBA eXtensible Interface).

A layerset 2 may further comprise or be associated with a layerset output CIU (also called "second layerset CIU' or 'internal combining unit') configured to combine the core filter outputs (up to $n_i$ core filter outputs) provided by the filter cores 22 of the layerset 2 into a single output feature stream. The output feature stream forms the layerset output that is delivered at the output of the layerset 2.

In some embodiments, at least some of the layersets 2 may be interconnected by one or more associated layerset configurable interconnection units (CIU) 24 and 25, so that the output of at least one layerset $2_i$ (for example $2_1$ in figure 1A) forms the input of a next layerset $2_{(i+1)}$ (for example $2_2$ in figure 1A), without intermediary storage of the output of the layerset $2_i$ prior to transmission of the output of the layerset $2_i$ to the next layerset $2_{(i+1)}$, while the two interconnected layersets are operating in parallel in a pipelined fashion, as depicted in figure 1A.

Assuming that P interconnected layersets 2 are used for the processing of an input feature map $I$, each interconnected layerset $2_i$ from $i = 1$ to $i = P - 1$ may be configured to perform the equivalent computation of the $i$-$th$ convolutional layer of the CNN, without writing the intermediate output of the $i$-$th$ layerset $2_i$ (layerset output), in an external memory. The $P$-$th$ layerset $2_P$ corresponding to $i = P$ provides the output feature map of P-th layer that may be stored in the external memory 30. This enables merging P convolutional layers. As used herein, merging P convolutional layers means performing the equivalent computation of P convolutional layers of the CNN without writing the P-1 intermediary results (for $i = 1$ to $P - 1$) in an external memory.

For example, in the case of figure 1B, the first layerset $2_1$ receives its input from the layerset input CIU 24 associated with the layerset $2_1$ and the output streams delivered by the filter cores 22 of the layerset $2_1$ are combined in the layerset output CIU 25 of the layerset $2_1$, The second layerset $2_2$ receives its input stream from the layerset output CIU 25 of the first layerset $2_1$ and the third layerset $2_3$ receives its input from the layerset output CIU 25 of the second layerset $2_2$

The layerset input CIU 24 associated with each layerset $2_1$, $2_2$, and $2_3$ is configured to receive an input stream and broadcast it to the filter cores 22 of the corresponding layerset, while the outputs of the filter cores 22 of the corresponding layerset are combined by the associated layerset output CIUs 25 and transmitted to the next layerset.

In particular, the layerset input CIU 24 associated with the first layerset $2_1$ is configured to receive a serialized vector determined by the serializer 3 and broadcast it to the used filter cores 22 of the first layerset $2_1$ (the first layerset $2_1$ using $n_1$=3 filter cores 22). The layerset output CIU 25 associated with the first layerset $2_1$ is configured to combine the output of the three used filter cores 22 of the considered layerset $2_1$, which provides the first layerset output, and transmit the first layerset output to the second layerset $2_2$. The second layerset $2_2$ uses $n_2$=2 filter cores 22. The layerset input CIU 24 of the second layerset $2_2$ is configured to receive the first layerset output (received from the first layerset $2_1$ through the layerset output CIU 25) and to broadcast it to the two filter cores 22 of the second layerset $2_2$. The layerset output CIU 25 corresponding to the second layerset $2_2$ is configured to combine the output of the two filter cores 22 of the second layerset $2_2$, and transmit it to the third layerset $2_3$ which comprises only one filter core 22 ($n_3$=1). The output of the filter core of the third layerset $2_3$ provides the third layerset output, corresponding to the output feature map of the accelerator 1. The third layerset output, corresponding to the output feature map of the accelerator 1, may be stored in the output memory 30.

The first layerset $2_1$ is configured to perform the equivalent computation of the first convolutional layer $L_1$ of the CNN without writing the intermediary output of the first layerset $2_1$ in an external memory. The second layerset $2_2$ is configured to perform the equivalent computation of the second convolutional layer $L_2$ of the CNN without writing the intermediary output of the second layerset $2_2$. In this example, this enables merging P =3 convolutional layers of the CNN (i.e. performing the equivalent computation of 3 convolutional layers of the CNN without writing the intermediary layerset output of the first layerset $2_1$ and of the second layerset $2_2$ in an external memory).

More generally, in response to a received input feature map, the CNN accelerator 1 may select P layersets 2 for the computation of the output feature map delivered by the CNN accelerator 1. The CNN accelerator 1 may then interconnect the P layersets $2_i$ (P being an integer at least equal to 2), such as the output of each layerset $2_i$ for $i = 1$ to $P - 1$

forms the input of the next layerset $2_{i+1}$ interconnected thereto, the output of the last interconnected layerset $2_P$ providing the output feature map that may be stored in external memory (for example through DMA, in the external memory 30 is a DDR memory). The $i$-$th$ layerset $2_i$ may be configured to perform the equivalent computation of the $i$-$th$ convolutional layer of the CNN, while the P-1 intermediary outputs of the layersets $2_i$ for $i$ = 1 to $P$ - 1 are directly sent to the next interconnected layerset, $2_{i+1}$ without intermediary storage in an external memory (thereby, P convolutional layers of the *CNN* are merged in this case).

In response to the receipt of the input feature map, the serializer 3 may initially send a first serialized vector to the first layerset ($2_1$) which is adapted to process the received serialized vector, determine its layerset output, and directly send the layerset output of this first layerset to the next layerset ($2_2$), without intermediary storage. In the next processing iterations, for each index $i$ = 2 to P- 1, each layerset $2_i$ of the interconnected layersets directly (i.e. without intermediary storage) may receive as input the output stream delivered by the previous layerset $2_{i-1}$ and process it in parallel to the other layersets 2. The 'parallel' and "pipelined" processing implemented by the layerset 2 means that the previous layersets among the P selected layersets, in the interconnection layerset chain, may continue to process in parallel other serialized vectors resulting from the serialization of the input feature stream, while the next layersets in the interconnected chain may be terminating the processing of a current serialized vector.

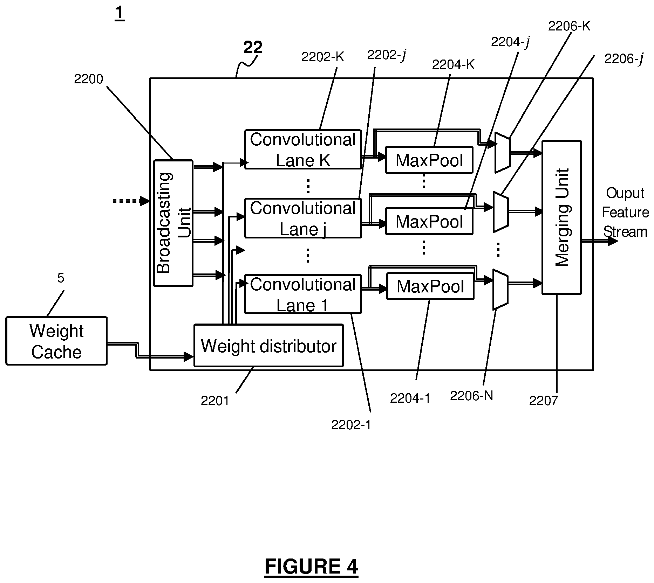

Figure 4 is a detailed view of the structure of a filter core 22, according to an exemplary hardware implementation.

The input feature stream received by a layerset 2, and the data stream transmitted by the main CIU 4 form a data stream having a width, such as for example an AXI stream of width.

The outputs of the filter core 22, and the output of the CIU 25 may also form a data stream having a given width, such as for example an AXI stream.

The accelerator 1 comprises a weight cache 5 configured to store weights (also called 'coefficients') of the CNN and distribute the stored weights to the different filter cores 22 of the layersets 2, the weights being used by each filter core 22 to perform CNN convolution operations.

The weight cache 5 may be configured to determine sets of weights to be distributed to each filter core 22.

In some embodiments, the weight cache 5 may be on-chip weight memory, which can be for example a RAM.

The weights may be previously learnt during a training phase, for example in a cloud.

The weight cache 5 may be configured to distribute differently the weights depending on the received serialized vectors.

The weight stream transmitted by the weight cache 5, and the data stream transmitted by the layerset input CIU 24 of a layerset 2 to the layerset filter cores 22 may form a data stream having a width, such as for example a AXI stream of width.

Each filter core 22 may receive the input feature stream received by the associated layerset 2.

Each filter core 22 corresponds to a convolutional filter forming a weight matrix of height $f_h$ and width $f_w$ comprising the weights applied to the filter core 22.

The convolutional filter has therefore dimensions $f_h \times f_w$, where $f_h$ is the filter height and $f_w$ is the filter width.

Each filter core 22 comprises $K$ convolutional lanes 2202 configured to process the input feature stream received by the filter core 22 in parallel, using weights among the weights transmitted to the filter core 22 by the weight cache 5. A filter core 22 may comprise a weigh distributor 2201 to distribute the weights to the convolutional lanes 2002.

Each convolutional lane 2202 may be configured to simultaneously compute one row of the output feature map delivered by the accelerator 1 using the received input feature stream and a weight stream. 22.

Each filter core 22 may comprise an elementary broadcasting block 2202 configured to broadcast the received input feature stream to the different convolution lanes 2002.

The convolution lanes 2202 may be configured to apply one filter, also called elementary filter, to the input data stream received by the filter core 22, which provides a convolutional lane output for each convolution lane 2202. The elementary filter applied by a convolutional lane 2202 is defined by a subset of weights received by the convolutional lane 2202. In embodiments using layersets 2 mapped to c clusters, the architecture of the accelerator 1 supports up to c clusters 2, each with up to $n$ filter cores 22, each core 22 comprising $K$ convolutional lanes, allowing up to $c \times K$ filters to be applied in parallel ($P \times K$ if $P$ clusters are interconnected, out of the c clusters, for the processing of the current input feature map 1).

The weight distributor 2201 may be configured to read and distribute subsets of weights, each subset of weights corresponding to a convolutional lane 2202, from an on-chip memory. This allows for more optimized data reuse (expressed in terms of MAC/Data).

The filter weights data reuse is of $H \times W$ MAC/data, and the input feature map data reuse is of $K$ MAC/data.

Index $j$ will be used to distinguish the convolutional lanes, the $j$-th convolutional lane being thereby denoted 2202-$j$. Each convolutional lane 2202-$j$ is configured to perform a convolutional operation using the weights received from the weight distributor 2201 and determine one row of the output feature map. The different convolution lanes 2202 are configured to operate simultaneously.

Each convolutional lane 2202-$j$ is configured to receive two streams comprising the input feature stream and the corresponding weight stream input applied to the convolutional lane. Each convolutional lane 2202-$j$ may be configured to receive the weights continuously. For example, for a full layer operation, each convolutional lane 2202-$j$ may receive $f_h \times f_w \times$ C weights, repeated $H \times W$ times.

The weight distributor 2201 may be configured to distribute the $K$ filter weights received by the filter core 22 to $K$ convolutional lanes 2202 from an on-chip weight memory (such as a RAM).

In some embodiments, each filter core 22 may optionally comprise a plurality of Max Pooling blocks 2204 associated with the convolutional lanes 2202. For example, the Max Pooling blocks 2024 may comprise a Max Pooling block associated with a respective convolutional lane 2202 (i.e. the number of convolutional lanes is equal to the number of Max Pooling blocks). A Max Pooling block 2204 may be arranged at the output of the associated convolutional lane 2202 and may be configured to receive the convolutional output determined by the associated convolutional lane 2204 and to apply a sliding window across the values of the convolutional lane output to select the maximal values within the window. Each maximum value becomes a single pixel in the new pooled output. The window is then slid across the convolutional lane output received by the Max Pooling block 2204 by a stride of a certain number of pixels, and the process is repeated until the entire convolutional lane output has been processed.

A Max Pooling block 2204 (the $j$-th max poolng block being also denoted 2204-j) is configured to process the outputs as they are generated by the associated convolutional lane, thereby optimizing performance by overlapping convolution and pooling operations.

The Max Pooling blocks 2204 can start processing the values of the convolutional lane outputs immediately when they are available, without requiring prior storage of the outputs of the convolutional lanes 2202. The sliding window has a given size and a given stride. For example, the sliding window can have a size 2×2 and a stride equal to 2 (i.e. the stride with which the window is moved is 2 pixels).

This allows for applying the Max Pooling processing on the received data stream immediately without the need to save results into memory. This may be implemented by merging several convolutional layers 2202, one after another. For example, this may be implemented by dedicating 2 convolutional lanes per data stream, effectively allowing for output feature map elements to be generated for the Max Pooling block 2204 to start processing them using a 2×2 window. In such cases, the max pooling blocks 2204 and the convolutional layers 2202 may be merged.

This allows for a significant improvement in performance as the Max Pooling blocks 2204 are not idle waiting for data to be routed through memory first, thereby minimizing the need to save outputs into memory negatively impacting performance. Max Pooling enable reducing the size of the outputs delivered by the convolutional layers.

Each filter core 22 may further comprise a merging unit 2207 configured to merge the results returned by the max pooling blocks 2204-$j$ through multiplexer blocks 2206-$j$ (generally referred to as 2206, while the $j$-th multiplexer is denoted 2206-$j$). Each block 2206-$j$ may be associated with a max pooling block 2204 and be configured to select if the associated max pooling block 2204 is used or not.

The merging unit 2207 may be configured to merge the different rows of the output feature map generated by the $K$ convolutional lanes 2202, after the max pooling operation performed at the respective max pooling blocks 2024.

Each filter core 22 of a given layerset 2 is configured to deliver an output feature stream corresponding to the merged outputs of the max pooling blocks 2204. These output feature streams of the filter cores may then combined by the layerset output CIU 25 of the layerset 2.

Each convolutional lane 2202-$j$ of the filter core 22 thereby generates a row of the output feature map simultaneously to allow the corresponding Max Pooling block 2204 start processing the feature map elements as soon as they become available. Indeed, a Max Pooling operation performed by a Max Pooling block 2204 requires receiving two output rows. With the arrangement of the filter cores 22, in the embodiments of the disclosure using max pooling, the two output rows can come out simultaneously so that each Max Pooling block 2204 can start the max pooling operation immediately, as opposed to waiting for the second row.

It should be noted that although the description of embodiments of the disclosure will be made with reference to the use of Max Pooling Blocks 2204 for illustration purpose, the disclosure is not limited to the use of Max Pooling Blocks 2024 downstream the convolutional lanes 2202. Therefore, in some embodiments, a filter core 22 may be implemented without using Max Pooling Blocks 2024. In this case, prior storage of the outputs of the convolutional lanes 2202 before transmission to the merging unit 2207 is not required either, and each filter core 22 of a given layerset 2 is adapted to deliver an output feature stream corresponding to the merged outputs of the $N$ convolutional layers 2202.

Further, although the description of some embodiments of the disclosure will be made with reference to a filter core 22 comprising as many max pooling blocks 2204 as the number of convolutional lanes 2202, the skilled person will readily understand that the embodiments of the disclosure where Max Pooling Blocks 2204 are used are not limited to the use of as many max pooling blocks 2204 as the number of convolutional lanes 2202 in each filter core 22 (a filter core 22 may therefore comprise a number of max pooling blocks 2204 that is different from the number of convolutional lanes 2202).

The CNN accelerator 1 is therefore capable of applying up to $c \times n \times K$ filters in one iteration in embodiments using c clusters mapped to the $L$ layersets 2 (for example $c \times n \times K = 4 \times 4 \times 32 = 512$ in the examples of figure 1A). This advantageously allows for implementing large convolutional layers within a low number of iterations. Each of the convolution lanes 2202 of a filter core 22 comprised in a given layerset 2 may be tasked with applying one filter, effectively allowing $L \times n \times K$ filters to be applied in parallel.

Each filter core 22 may comprise one or more FIFOs (not represented) for receiving the incoming data streams from each convolutional layer 2202-j, the one or more FIFOs being accessed by the corresponding MaxPool block 2204-j. The use of FIFOs enables the MaxPool blocks 2204 to start the scanning window process immediately. In one embodiment, each filter core may comprise for example two FIFOs.

In the following description, it will be considered that the number of FIFOs is equal to the number of rows required for the sliding window. However, additional FIFOs may be mapped per convolutional lane 2202 to pre-buffer incoming data for the MAC core to support the continuous streaming of data. The MAC core is configured to perform multiplication and accumulation operations.

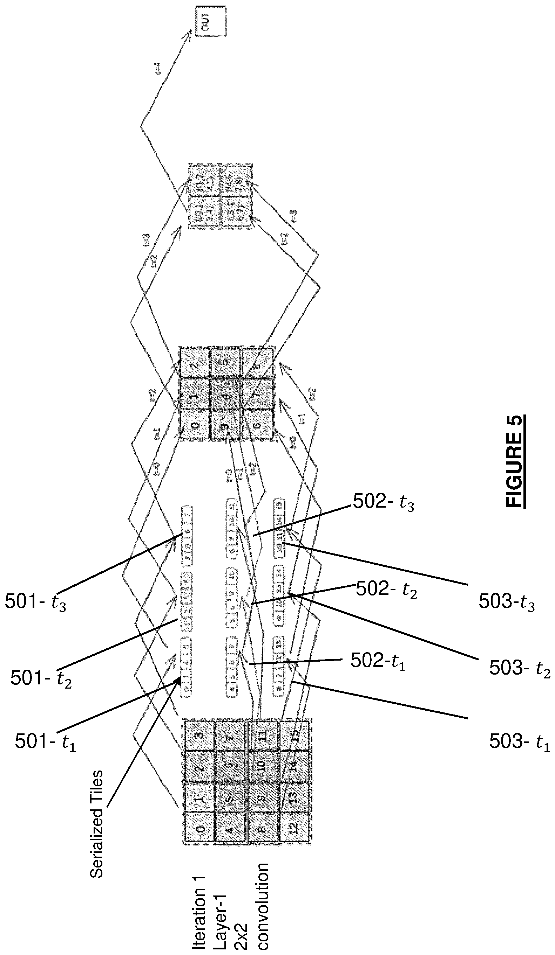

Figure 5 depicts the 'look-ahead' scheme in embodiments where three convolutional layers are merged in one iteration, to obviate the need for intermediary storage in a memory. Figure 5 corresponds to the example represented figure 1B.

In the look-ahead scheme of figure 5, two convolutional layers are merged comprising a first convolutional layer (Layer-1) having a filter size equal to $2\times2$ and a second convolutional layer having a filter size equal to $2\times2$. The second layer requires rows 0 and 1 to apply the filter immediately without buffering results. In order to achieve this, the look-ahead scheme according to the embodiments of the disclosure is used on the previous layer by fetching the required data streams from memory and mapping an additional computational lane, so that the two lanes process incoming data in parallel and generate two rows of output feature elements for the second layer. The second layer applies the $2\times2$ filter on the available elements as they are streamed in from the first layer without the need to save them into external memory and fetch them for computation.

In figure 5, the parameter $t$ indicates the clock cycle at which the outputs are calculated.

In the example of figure 5, P=2 convolutional layers are merged meaning that the output of the first layerset $2_1$, corresponding to the equivalent computation of the first convolutional layer 'Layer 1' of the CNN (in the first iteration) is not written in an external memory, and transmitted to the second layerset $2_2$ directly. The second layerset $2_2$ determines in the second iteration, the equivalent computation of the first convolutional layer 'Layer 2' of the CNN, and outputs the final result of the two convolutional layers, that can be then written in the external memory 30. This is enabled by the serialization of the input feature map $I$. As shown, the serialization of the input feature map $I$ is useful for the first layer coming from memory. For the following layers, the output rows are streamed in parallel.

In Figure 5, the serialized convolutional patches (streams) are denoted by references 501, 502, 503, .., 509.

In the example of figure 5, the streams 501, 502 and 503 are fed to the cores 101, 102 and 103 of the first layerset $E_1$ respectively. The convolutional patches are denoted 501-$t_i$, 502-$t_i$, and 503-$t_i$ ($t_i$=$t_1$ to $t_3$ with $t_1$=1, $t_2$ = 2, and $t_3$ = 3) and correspond to the serializer 3 output in figure 1B which is a continuous stream of data. The data at time $t_i$ is denoted as 501-$t_i$, 502-$t_i$, and 503-$t_i$.

501-$t_1$, 501-$t_2$, 501-$t_3$ form the sequence of vectors in the same data stream.

In contrast, in the prior art implementations, two convolutional layers are executed one after another in series, and the intermediate results need to be written back to a memory. This requires two iterations, with a first iteration taking 8 clock cycles and the second iteration taking 4 clock cycles.

The accelerator 1 according to the embodiments of the disclosure therefore results in an improvement in performance while providing a more flexible design space for trade-offs latency versus resources trade-off.

The accelerator 1 can be easily implemented and integrated while reducing off-chip memory access by merging layers. Further it enable improving throughput and reduce latency, while supporting continuous streaming interface.

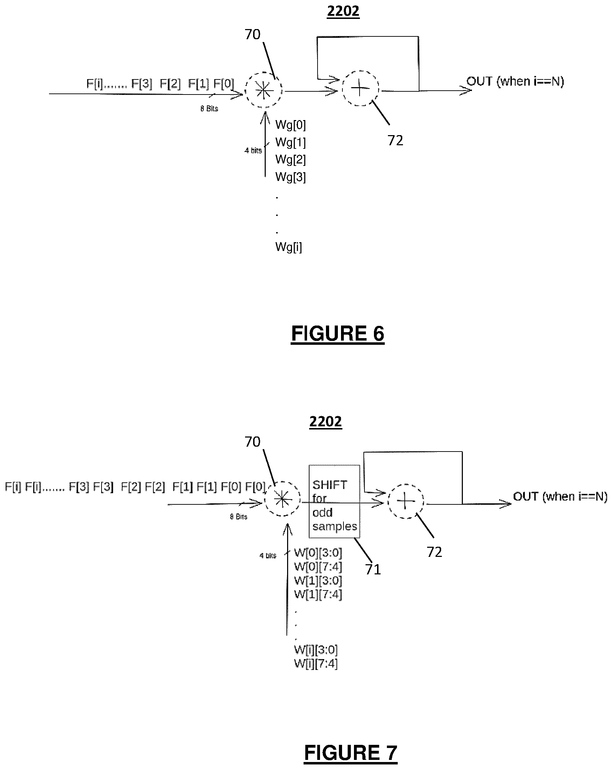

Figure 6 represents the processing of a convolutional lane 2202, according to an exemplary embodiment where each convolutional lane 2202 is configured for a 8-bit feature map, and 1, 2, 4 bit weights, while figure 7 represents the processing of a convolutional lane 2202 according to an exemplary embodiment where each convolutional lane 2202 is configured for 8-bit feature map, and 8 bit weights. The same data path may be used for different weight width, depending on the application.

Each convolutional lane 2202 is configured to receive an input feature maps stream, denoted F[.], and a weight stream corresponding to the subset of weights received by the convolutional lane, denoted Wg[.] received from the weight distributor 2201.

The index $i$ used in this example is independent from the index $i$ used to refer to the layersets 2.

In the example of figures 6 and 7, the input streams F comprise F[i], ....F[3], F[2], F[1] and F[0] (comprising 8 bits in the example of figure 6, while the weight stream WGHT comprise Wg[0], Wg[1], Wg[2],..., Wg[i] comprising 4 bits in the example of figure 7), with $i$ ranging from 1 to N (with $N$ being equal to total filter length in this diagram, i.e. $N = f_h \times f_w \times C$).

As shown in Figures 6 and 7, each convolutional lane 2202 may comprises an inner product block 70 (also called 'multiplier' configured to perform the inner product of the input feature map stream F, received by the filter core 22, and the weight stream W received from the weight distributor 2201).

Each convolutional lane 2202 may further comprises an adder 72 configured to perform the addition of the result returned by the inner product block 71 and of the previous output of the adder 72.

The input feature map stream F may be then redirected to a suitable convolutional lane 2202 according to a chosen bit precision. In some embodiments, a convolutional lane 2202 may support a number of bit precisions, such as 1/2/4, for the weights Wg and use an input feature map stream comprising a number of bits.

In the example of figure 6, a convolutional lane 2202 supports three bit precisions corresponding to 1, 2 or 4 bit precisions for the weights while it uses a number of bits equal to 8 bits for the input feature map stream $F$.

A bit precision equal to $A$ for the weights indicates that they comprise $A$ bits that can represent $2^A$ values.

In the example of figure 6, a convolutional lane 2202 supports three bit precisions corresponding to 8 bit precisions for the weights while it uses a number of bits equal to 8 bits for the input feature map stream $F$.

Therefore the CNN convolutional layers according to the embodiments of the disclosure can be advantageously merged for continuous processing.

The serializer 3 may be arranged after the input memory 3 and before the main configurable interconnection unit 4. This ensures that the serialized data is efficiently distributed to the layersets.

The distribution of the serialized 1D vectors determined by the serializer 3 is managed by the configurable interconnection units 4, 24 and 25 to ensure that each filter core 22 in an interconnected layerset 2 receives the appropriate data stream.

The architecture of the CNN accelerator 1 is pipelined to ensure continuous data flow and maximize throughput. It comprises several pipeline stages include the loading data from memory, the serialization performed by serializer 3, the data broadcasting performed by the configurable interconnection units 4, 24 and 25, and the convolution operations performed by the filter cores 22.

The embodiments of the disclosure provide a hardware implementation of convolutional neural networks (implementable on semiconductors) that is particularly suitable for edge applications. The architecture of the accelerator 1 allows for an ultra-low-power yet high-performance deployment of CNNs on-chip, easy prototyping and implementation of deep learning models on hardware. It further provides an easy way to deploy quantized models with low precision weights and features without a significant loss in accuracy. The architecture of the accelerator 1 also allows for the efficient deployment of CNNs. Further, it makes it easy to customize and reconfigure the design to deploy any CNN models with the supported layers.

Advantageously, the CNN accelerator 1 according to the embodiments of the disclosure enables a reduction of external memory accesses by merging different layers without requiring writing intermediate data or results to an external memory (e.g. DRAM).

It further reduces latency through the serialization of the input feature map performed by the serializer 3 that can stream data from an external memory 10 and process the data on the fly.

The CNN accelerator 1 according to the embodiments of the disclosure also provides as energy consumption reduction. In particular a customized bitwidth and be used for each application or dataset and the same circuit can be configured to various bit weight (for example 1, 2, 4, 8) and a bit feature operation (for example a 8 bit feature operation) without performance penalty. Further, in embodiments using sparsity encoding/decoding, the sparsity can be leveraged in deep layers of the CNN to avoid any computation involving zero.

The energy cost of hardware operations varies significantly, striking a balance between the accuracy of the model and the resource bill associated with it. The proposed accelerator supports low precision fixed point operations and parameters, allowing for the deployment of quantized models, such as 1/2/4 and 8 bit fixed point representation supported for the parameters and 8 bit for the input data.

In some embodiments, the CNN accelerator 1 may comprise an encoder (not represented) configured to compress the input feature map loaded from memory via the input memory 10 into an input buffer. The serialization device 3 may then receive the compressed input feature map processed by the encoder to transform it the serialized 1D vector. In such embodiments, the CNN accelerator 1 may also comprise a decoder (not represented) configured to decompress the data broadcast to the convolutional lanes, before they enter the convolutional lanes.

In some embodiments, the encoder may be a sparsity encoder and the decoder may be a sparsity decoder. In such embodiments, the sparsity encoder may be configured to insert sparsity information to the compressed data stream to enable the filter cores 22 only process non-zero elements, while skipping zeros. The sparsity may extract the sparsity information during decoding so that the filter cores 22 may use the extracted sparsity information to only process non-zero elements while skipping the zero elements.

The compressed data may be decoded when it is fetched back from memory.

The CNN accelerator 1 may use a control Logic (not represented) configured to direct the data flow based on the compressed format from the sparsity Encoder. The control logic may be implemented in the form of a finite state machine (FSM) configured to control reading of the compressed data and writing of output data.

The CNN accelerator may use a computation unit (not represented) configured to perform the convolution operations of the convolutional lanes 2202. The computation unit may be implemented using for example Digital Signal Processing (DSP) blocks available on the FPGA, if the CNN accelerator 1 is implemented on FPGA.

The CNN accelerator may use the Digital Signal Processing (DSP) blocks for the multiply-accumulate (MAC) operations of the MAC core. Each DSP block may handle for example a number of filters 22 (for example 2 filters), each performing a number of operations.

In embodiments using a sparsity encoder/decoder, the control logic may ensure that MAC operations are performed only for non-zero elements, while skipping flagged MAC operations for zero runs.

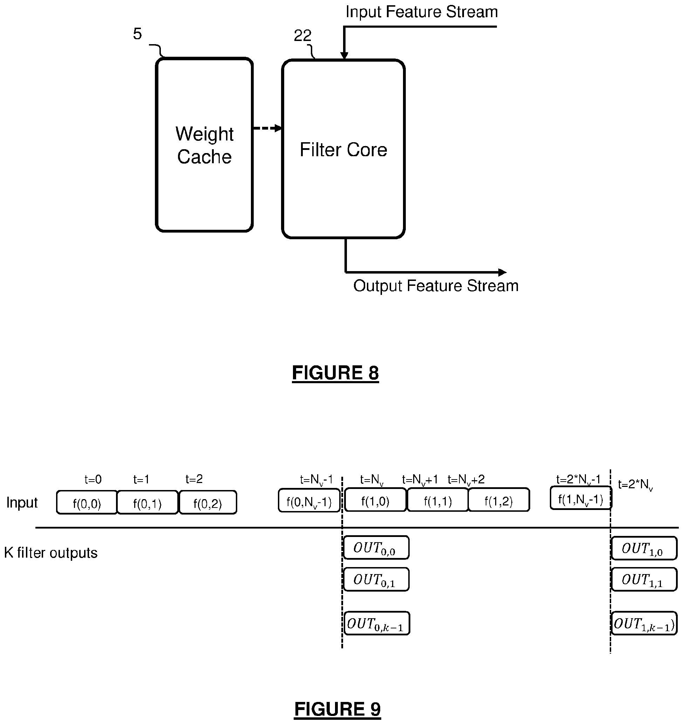

Figure 8 depicts the input and outputs of each filter core 22.

The input feature stream applied to a filter core 22 is a data bus having a given width $W_{core}$, such as for example a 8 bits width if a 8 bit quantization is used. A filter core 22 implements $K$ convolutional filters which provides $K$ convolutional filter outputs coming out the filter core 22 in parallel ($out0$, $out1$,..., $out(k-1)$), these $N$ convolutional filter outputs forming an output databus of width $W_{core}.N$. This databus of width $W_{core}.N$ (for example 8N) may be then transformed back to $W_{core}$ bits data bus (for example 8 bits data bus) using a width converter before transmitting it to other cores 22.

According to the embodiments of the disclosure, a series of 1D vectors $F_i$, each of size $N_v$ such as $F_i$: < $f_{i,0}$, $f_{i,1}$, $f_{i,2}$, ..., $f_{i,N_v-1}$ > may be generated by the serializer 3 from the input feature map $I$ (corresponding for example to an image or an audio input) and applied to the input of each filter core 22.

For example, considering an input feature map corresponding to an image of width $W$ and height $H$, then $Nv = f_h \times f_w \times f_c$, where $f_h$ and $f_w$ are the size of convolutional filters (e.g. $F_h = 3$, $F_w = 3$), $f_h$ being the filter height and $f_w$ being the filter width, and $f_c$ being the number of filter channel (corresponding to C for standard convolution). The total number of vectors in this case is equal to $H \times W$.

For example, considering $F_h = 3$, $F_w = 3$, $F_c = 3$, the total number of vectors is equal to 27. The first vector consists of the following elements $C_{HWC}$ with the notation $HWC$ denoting channel C at spatial coordinate < H, W >:

< $C_{000}$, $C_{001}$, $C_{002}$, $C_{010}$, $C_{011}$, $C_{012}$, $C_{020}$, $C_{021}$, $C_{022}$, $C_{100}$, $C_{101}$, $C_{102}$, $C_{110}$, $C_{111}$, $C_{112}$, $C_{120}$, $C_{121}$, $C_{122}$, $C_{200}$, $C_{201}$, $C_{202}$, $C_{210}$, $C_{211}$, $C_{212}$, $C_{220}$, $C_{221}$, $C_{222}$ >

According to another example, considering an input feature map corresponding to an audio sample of size $N_a$, there will be $N_a$ vectors $F_i$, each of size $Nv$ where $Nv = f_l * f_c$, $f_l$ being the length of the audio filter.

Both inputs and outputs of a filter core 22 are serial in time according to a cycle t.

Figure 9 depicts the streaming operation corresponding to the presentation of vectors $F_i$ (input feature stream) by the serializer 3 to a filter core 22 and the outputs feature stream obtained at the output of this filter core 22 at each clock cycle $t$:

- At cycle t=0, the first element $f_{0,0}$ of the first vector $F_0$ is presented at the input of the core filter 22;
- At cycle t=1, the second element $f_{0,1}$ of the first vector $F_0$ is presented at the input of the filter core 22, and so on for cycle t=2 to cycle t=$Nv$ - 2;
- At cycle t=$Nv$ - 1, the last element $f_{0,Nv-1}$ of the first vector $F_0$ is presented at input of the core filter 22.

At cycle t=$Nv$, the first element $f_{1,0}$ of the second vector $F_1$ is presented at the input of the core filter 22, while the filter core 22 generates and outputs the first element $OUT_0 = (OUT_{0,0}, OUT_{0,1}, ..., OUT_{0,k-1})$ of the K filter outputs such as:

$$OUT_{0,0} = \sum_{i=0}^{Nv-1} f_{0,i} \times W_{0,i} \,,$$

$$OUT_{0,1} = \sum_{i=0}^{Nv-1} f_{0,i} \times W_{1,i},$$

and so on until

$$OUT_{0,k-1} = \sum_{i=0}^{Nv-1} f_{0,i} \times W_{(k-1),i}$$

At cycle t=2 $*$ $Nv$, the filter core 22 generates and outputs the second element $OUT_1 = (OUT_{1,0}, OUT_{1,1}, ..., OUT_{1,k-1})$ of the K filter outputs such as:

$$OUT_{1,0} = \sum_{i=0}^{Nv-1} f_{1,i} \times W_{0,i} \,,$$

$$OUT_{1,1} = \sum_{i=0}^{Nv-1} f_{1,i} \times W_{1,i},$$

and so on until

$$OUT_{1,k-1} = \sum_{i=0}^{Nv-1} f_{1,i} \times W_{(k-1),i}$$

The filter core 22 proceeds similarly until cycle t=$(p - 1)_* Nv$ where the filter core 22 generates and outputs the p-th element $OUT_p = (OUT_{p,0}, OUT_{p,1}, ..., OUT_{p,k-1})$ of the K filter outputs such as:

$$OUT_{p,0} = \sum_{i=0}^{Nv-1} f_{p,i} \times W_{0,i} \ ,$$

$$OUT_{p,1} = \sum_{i=0}^{Nv-1} f_{p,i} \times W_{1,i},$$

and so on until

$$OUT_{p,k-1} = \sum_{i=0}^{Nv-1} f_{p,i} \times W_{(k-1),i}$$

The parameter $p$ is comprised between 0 and the maximum number of vectors $Fi$ (for example $H \times W$ for an input feature map corresponding to an image).

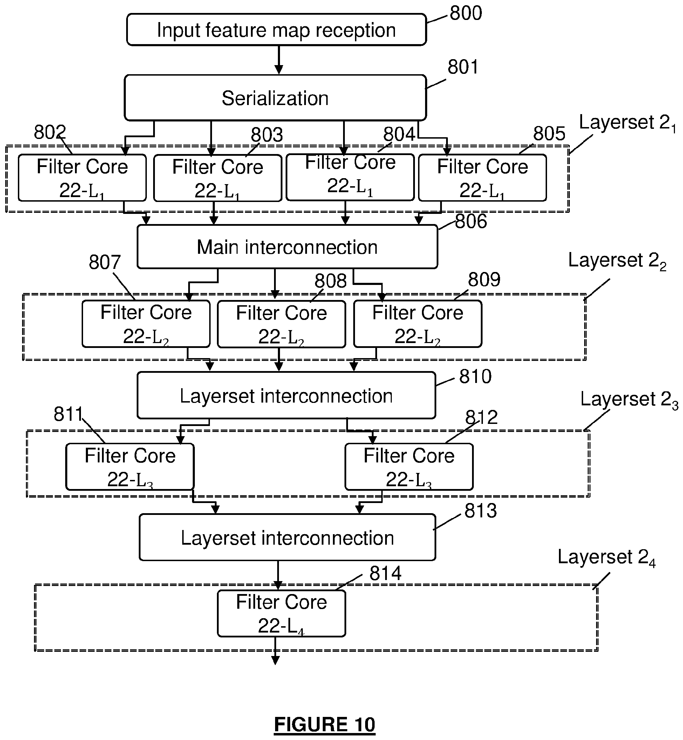

Figure 10 represents another exemplary implementation of the layersets 2 to merge P = 4 convolutional layers of the CNN.

In the example of figure 10, four interconnected layersets $2_i$ are used ($L = 4$), the first layerset $2_1$ (comprising $n_1$=4 filter cores 22) being adapted to perform the equivalent convolutional operation of the first CNN convolutional layer $L_1$, the second layerset $2_2$ (comprising $n_2$=3 filter cores 22) being adapted to perform the equivalent convolutional operation of the second CNN convolutional layer $L_2$, the third layerset $2_3$ (comprising $n_3$= 2 filter cores 22) being adapted to perform the equivalent convolutional operation of the third CNN convolutional layer $L_3$, and the fourth layerset 2,(comprising $n_4$= 1 filter core 22) being adapted to perform the equivalent convolutional operation of the fourth CNN convolutional layer $L_4$.

Turning back to figure 10, the output of the first layerset $2_1$ layer forms the input stream applied to the second layerset $2_2$, the output of the second layerset $2_2$ forms the input stream applied to the third layerset $2_3$, the output of the third layerset $2_3$ forms the input stream applied to the fourth layerset $2_4$ The output of the fourth layerset $2_4$ constitutes the result of the output feature map determined by the accelerator 1.

More generally, to merge $P$ CNN convolutional layers with a filter size equal to $m \times m$, $N + m$ - 1 lines (i.e. rows) of the input feature stream $I$ may be processed simultaneously, so that $P + m$ - 1 cores may be used. To merge $P$ CNN convolutional layers, $P$ stages (i.e. $P$ layersets) may be needed, with each layerset 2 comprising $(P - k + m - 1)$ cores 22 for the $k$ -th stage (i.e. layerset).

Merging P CNN convolutional layers (i.e. computing the P convolutional layers on chip without writing the intermediate results to an external memory) enables saving important power.

Figure 10 illustrates the Look-Ahead Convolution according to the embodiment of the disclosure that is adapted to merge the 4 CNN convolutional layers $L_1, L_2, L_3$, and $L_4$, using the 4 layersets $2_1, 2_2, 2_3$ and $2_4$ (four stages), according to an example using convolutional layers with 2x2 filters and 10 filter cores 22.

In step 800, the input feature map $I$ is accessed through the external memory 10, such as for example through DMA if the external memory is a DDR memory.

In step 801, the input feature map is serialized into a series of 1D vectors $F_i$ and the serialized vectors are presented to the 4 filter cores 22 of a first layerset $2_1$ in a first stage corresponding to steps 802, 803, 804, 805 to perform in parallel the convolutional operation corresponding to the first convolutional layer $L_1$. The outputs of the filter cores 22 of a first layerset $2_1$ are combined by the output CIU 25 of a first layerset $2_1$ and directly sent (i.e. without intermediary storage) to a second layerset $2_2$ (step 806).

The received output of the first layerset $2_1$ is processed in parallel by three filter cores of the second layerset $2_2$, in a second stage, corresponding to steps 807, 808, 809, that perform the equivalent convolutional operation corresponding to the second CNN convolutional layer $L_2$. The outputs of the filter cores 22 of the second layerset $2_2$ are combined by the output CIU 25 (step 810) of the second layerset $2_2$ and directly sent (i.e. without intermediary storage) to a third layerset $2_3$.

Similarly, the received output of the third layerset $2_3$ is processed in parallel by two filter cores of the third layerset $2_3$, in a third stage, corresponding to steps 811, and 812, that perform the equivalent convolutional operation corresponding to the third CNN convolutional layer $L_3$. The outputs of the filter cores 22 of the third layerset $2_3$ are combined by the output CIU 25 (step 813) of the third layerset $2_3$ and directly sent (i.e. without intermediary storage) to a fourth layerset $2_3$, which similarly performs, in a fourth stage, the equivalent convolutional operation corresponding to the fourth CNN convolutional layer $L_4$ using one filter core 22 in step 814. The output of the fourth layerset $2_4$ provides the output feature map determined by the accelerator.

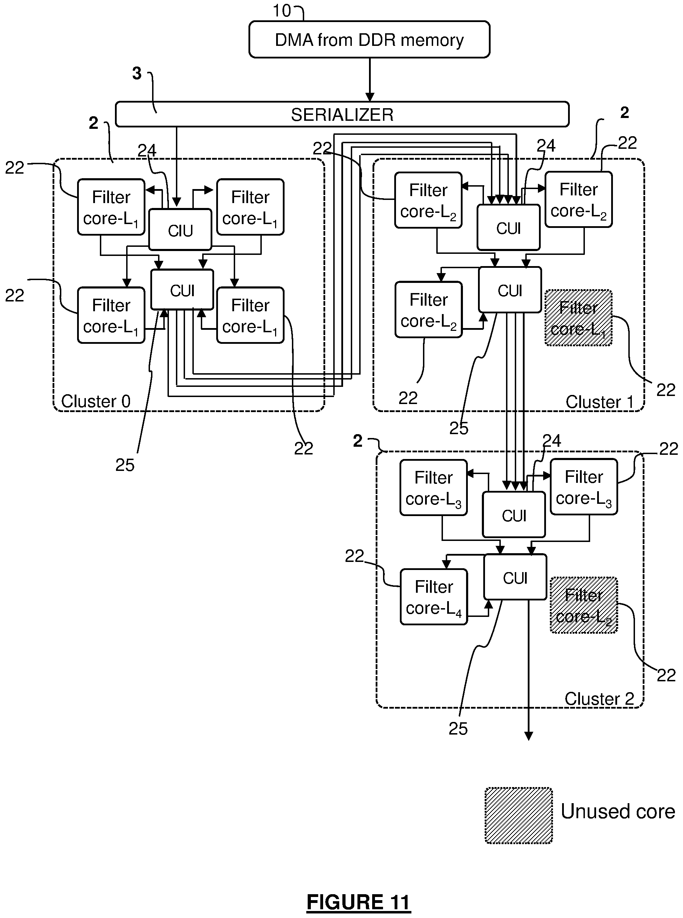

Figure 11 is a diagram representing an exemplary implementation of accelerator 1 according to the pipelined process illustrated by figure 10. Figure 11 shows the interconnection between the four layersets $2_1$, $2_2$, $2_3$ and $2_4$ using associated CIUs 24 and 25. The four layersets $2_1$, $2_2$, $2_3$ and $2_4$ may be implemented in three clusters denoted 'cluster 1', 'cluster 2' and 'cluster 3', each comprising of $n = 4$ filter cores 22. The first layerset $2_1$ is implemented in a single cluster 'cluster 1'. The second layerset $2_2$ is implemented in a single cluster 'cluster 2' comprising one unused core. The third and fourth layersets $2_3$ and $2_4$ are implemented inside the third cluster 'cluster 3' which comprises one unused core.

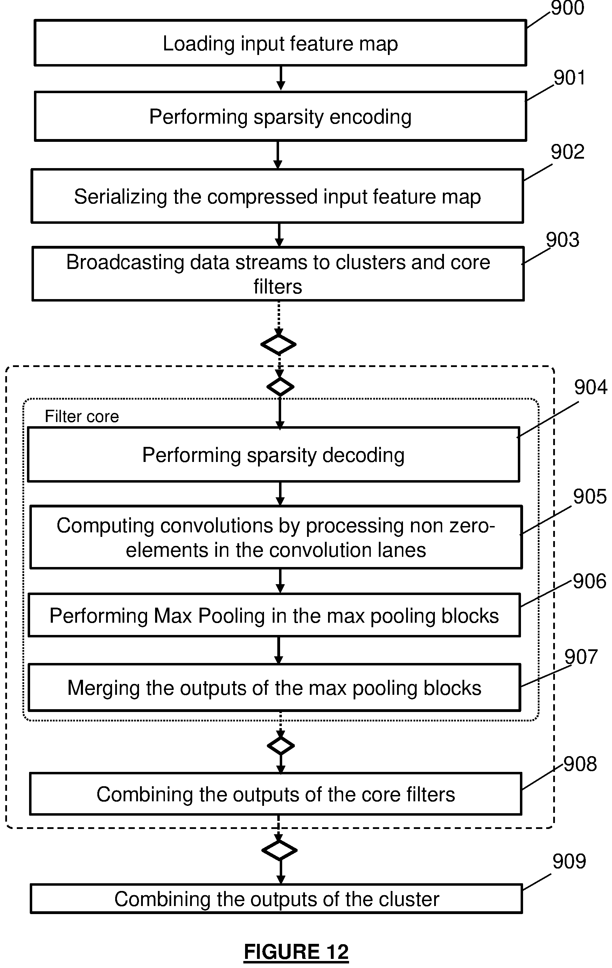

Figure 12 depicts the method implemented by the accelerator 1 to determine an output feature map in response to a received input feature map, according to some embodiments.

In step 900, the input feature map may be loaded from the internal memory 10, for example via DMA, into an input buffer.

In step 901, sparsity encoding may be performed to compress the input feature map using a sparsity encoder block.

In step 902, the compressed input feature map is serialized into a set of 1D vectors.

In step 903, the serialized data generated in step 902 may be broadcasted to the pipelined filter cores 22, using the configurable Interconnection units 4, 24, 25. In each iteration, a set of filter cores 22 comprised in a layerset 2 may be used to perform the equivalent convolutional operation of a given CNN layer, while the output of this iteration is not stored and is directly sent to an interconnected layerset 2, operating in parallel, which is adapted to perform the equivalent convolutional operation of another CNN layer, which enables merging layers of the CNN.

More specifically, in each filter core 22 of a layerset 2:

In step 904, before entering the convolutional lanes 2202 in each filter core 22 of a layerset 2, the data stream may be decompressed by a sparsity decoder block.

In step 905, the convolutional lanes process the non-zero elements, while skipping zeros as the sparsity information directs.

In step 906, max pooling may be applied to the output of each convolutional lane 2202, at the associated MaxPool block 2204, for real-time processing without storing intermediate results.

In step 907, the outputs from the max pooling blocks 2204 may be merged, the merged output providing the filter core output.

In step 908, the outputs from the filter cores 22 of the considered layerset 2 may combined, which provides the layerset output.

In step 909, the outputs from the layersets 2 are combined and the resulting combined output is sent back to memory via DMA 30, which provides the output feature map.

The CNN accelerator 1 according to embodiments of the disclosure may be used in various edge deep learning applications such as for example in preventive maintenance (e.g. to control battery replacement) or in precision agriculture. The embodiments of the disclosure may be also applied in other applications fields such as for example industrial inspection, road infrastructure, video surveillance, domestic robotics, industrial robotics, automated checkout, infrastructure inspection, military applications, satellite imaging, Internet of Things, voice assistance, etc.

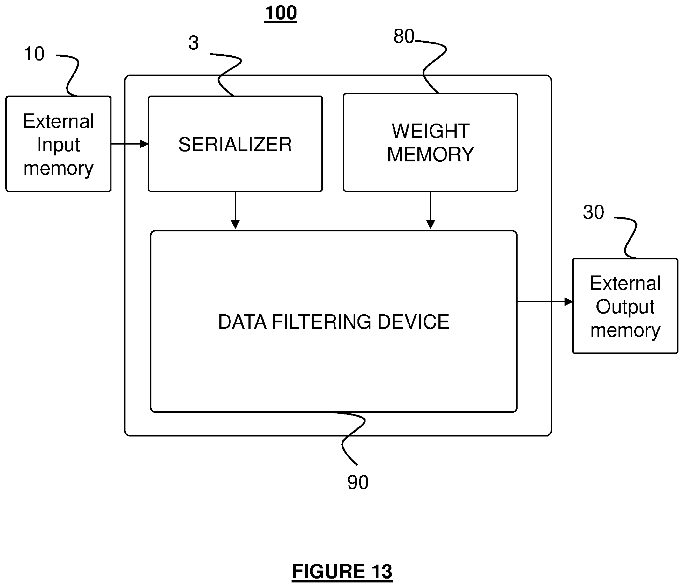

Although some aspects of the disclosure are herein described jointly, the skilled person will readily understand that some of these aspects of the disclosure may be used separately and independently, such as for example the serializer 3. Indeed, the skilled person will readily understand that the serializer 3 may have a separate interest for use in any convolutional filtering system not limited to the accelerator 1, as described in relation with figures 13 to 19. Similarly, the skilled person will readily understand that the accelerator 1 is not limited to the use of the implementation of the serializer 3 described in relation with figures 13 to 19, and may use any other suitable implementation of a serializer 3.

The serializer 3 may be configured to receive at its input a $Q$-Dimensional tensor $I$ corresponding to the input feature map that is to be serialized by the serializer 3.

The following description of some embodiments will be made with reference to a 3-D tensor $I$ may having three dimensions denoted $< H, W, C >$, where $H$ denotes the height of the input feature map, $W$ the width of the input feature map and $C$ denotes the number of channels of each element (for example each pixel if the input feature map is an image) of the input feature map. The input feature map may be for example an image or an audio file.

An element $I[i'][j'][k']$ of the original 3G tensor $I$ is defined by three indexes $i', j', k'$. In the example of an input feature map being an image, an element $I[i'][j'][k']$ is an image pixel.

The serializer 3 is configured to extract a number of convolutional patches from the input tensor $I$, and outputs the extracted convolutional patches in the form of a series of one dimensional (1D) output vectors $F_i$, in a serial fashion, each extracted 1D vector corresponding to a convolutional patch.

Figure 13 represents a convolutional filtering system 100 in which the serializer 3 may be generally used. The convolutional filtering system 100 may be for example the CNN accelerator 1. However, although the serializer 3 has particular advantages for use in a CNN based accelerator 1, the serializer 3 may be used more generally in any convolutional filtering system.

The convolutional filtering system 100 comprises a convolutional filtering device 90 configured to filter the input feature map, represented by the 3D tensor $I$, after the serialization of the input feature map I by the serializer 3 into a series

of 1D vectors $F_i$.

The convolutional filtering device 90 may be for example constituted by a set of layersets 2, each comprising a number of filter cores, such as filter cores 22, adapted to apply convolutional filters.

More generally, the convolutional filtering device 90 is configured to implement convolutional filters, using dot product computing.

The convolutional patches extracted by the serializer 3 in the form of a series of 1D vectors $F_i$ may be fed to the convolutional filtering device 90 which is adapted to perform dot product operations using the extracted convolutional patches to implement convolutional filters.

Each convolutional patch extracted by the serializer 3 is defined by a position $< p, q >$ in the input tensor $I$ and has a size defined by two size parameters $f_h$ and $f_w$.

A convolutional patch at position $< p, q >$, of size $f_h$ and $f_w$, is defined as:

$$\bigcup_{i\prime=p}^{i\prime=p+f_w} \bigcup_{j\prime=q}^{j\prime=q+f_h} \bigcup_{j\prime=0}^{j\prime=C-1} I[i\prime][j\prime][k\prime]$$

The serializer 3 may be advantageously configured to extract several convolutional patches (more than 2) in parallel, without blocking the input feature map write process. By obviating the need for any blocking, the serializer 3 avoids adding delays in the further processing. In prior art serializers, a blocking might occur when using ports of a dual port memory simultaneously, and such ports read/write to the same address resulting in a conflict. The serializer 3 is advantageously configured to avoid any such conflicts.

The serializer 1 may implement a streaming mode among two streaming modes depending on the input feature map streaming.

In a first streaming mode (serial streaming mode), the 3D input tensor $I$ may be serially streamed to the serializer 3 in a row major order. This means that the input feature map is streamed according to a row major order by presenting 1 element of the input feature map $I$ (for example one pixel for an image input feature map) at a time. The following table 'Table 1' illustrates the first streaming mode, according to an example using an input feature map being an image. In this example, an input feature map $I$ element is serially presented at each instant time t:

Table 1

| Instant time | Pixel presented in the row major order |
|---|---|
| $t = 0$ | $I[0][0][0]$ |
| $t = 1$ | $I[0][0][1]$ |
| $t = C - 1$ | $I[0][0][C - 1]$ |
| $t = 2 * C - 1$ | $I[0][1][C - 1]$ |
| $t = 3 * C - 1$ | $I[0][2][C - 1]$ |
| $t = n * C - 1$ | $I[0][n][C - 1]$ assuming $n < W$ |
| $t = W * C - 1$ | $I[1][0][C - 1]$ |

In a second streaming mode (parallel streaming mode), the 3D input tensor $I$ may be streamed to the serializer 3 according to a parallel in column major order. In this second streaming mode embodiment, $K$ elements (for example $K$ pixels) of the input feature map may be presented at the input of the serializer 3, according to a column major order, as illustrated by the following example where the input feature map is an image):

Table 2

| Instant time | Pixels presented in the column major order |
|---|---|
| t=0 | $I[0][0][0], I[0][1][0], .... I[0][K - 1][0]$ |
| t=1 | $I[0][0][1], I[0][1][1], .... I[0][K -1][1]$ ... |

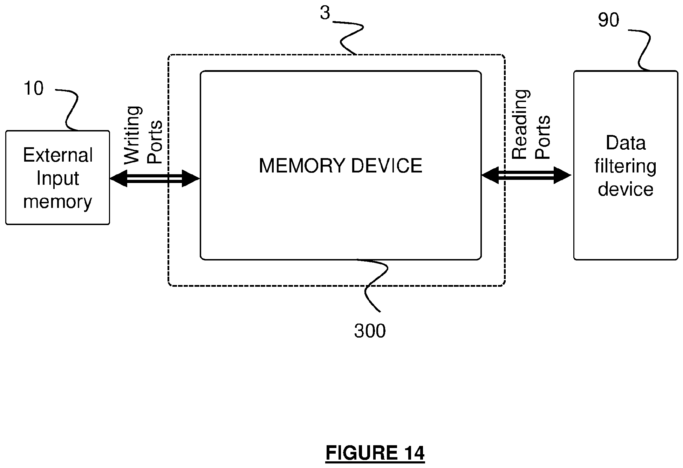

Figure 14 depicts the structure of the serializer 3, according to some embodiments.

The serializer 3 may comprise a memory device 300 comprising at least three ports with at least two reading ports, one of the ports being a writing port and the other two ports being a reading port.

The memory device 300 may comprise a plurality of memory banks, each memory bank comprising a plurality of addressable memory cells. Data words may be written to or read from the memory banks of the memory device 300.

The memory device 300 may be configured to store $N$ data words in addressed locations, each word comprising *Bbits* (bit width).

A writing port of the memory device 300 is configured to write data streamed to the serializer 3 to the memory device 300 (one word may be written per clock cycle) while a reading port of the memory device 300, for example 302, may be used to read data from memory. The dual memory operates according to a clock signal oscillating between a high and a low state at a constant frequency. Therefore, read and write operations may occur at a clock cycle (i.e. time interval between rising edges of a repetitive clock signal).

In some embodiments, the memory device 300 may be a dual-port memory assembly 300 comprising at least one dual port memory 30, each dual port memory comprising at least two ports.

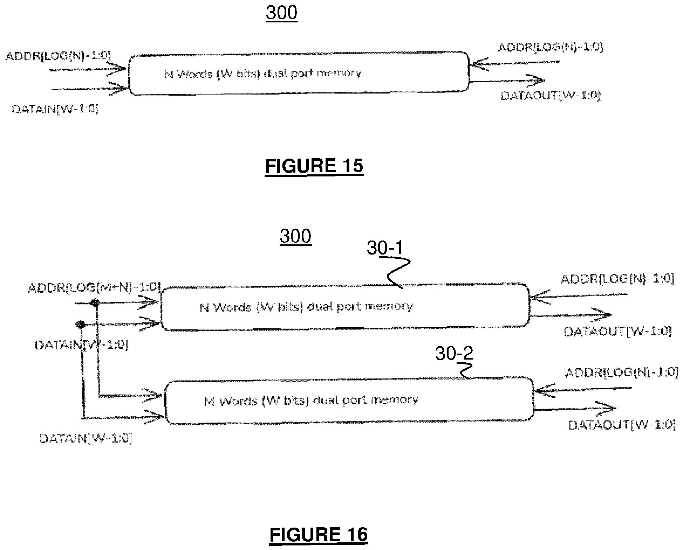

Figure 15 represents an exemplary implementation of the memory device 300 of the serializer 3 consisting of a single dual-port memory 30.

The single dual port memory 30 comprises two input ports 301 and 302, one of the two ports (referred to as the writing port), being a dual port memory 30 (for example port 301) used to write data to the dual port memory 30 (one word per clock cycle), while the other port (referred to as the reading port), for example 302, may be used to read data from the memory.

In figure 15, DATAIN[$W$-1;0] corresponds to a write operation at the writing port while DATAOUT[$W$-1;0] corresponds to a read operation at the reading port. ADDR corresponds to the address at which the data is written or read.

In some embodiments, the memory device 300 may be implemented using at least a dual memory assembly comprising more than two input ports. In such embodiments, the dual-port memory assembly 300 may comprise at least two combined dual port memories 30.

For example, the dual-memory assembly 300 may comprise one write port and two read ports, as illustrated in figure 16.

More generally, the dual-port memory assembly 300 may be formed by combining R dual port memories 30, R denoting the number of dual port memories used to implement the serializer memory, the memory device 300 then having 1 to R write ports and 1 to R read ports. For example, in figure 16, the dual-memory assembly 300 comprises two combined dual port memories 30-1 and 30-2 corresponding to two write ports and two read ports.

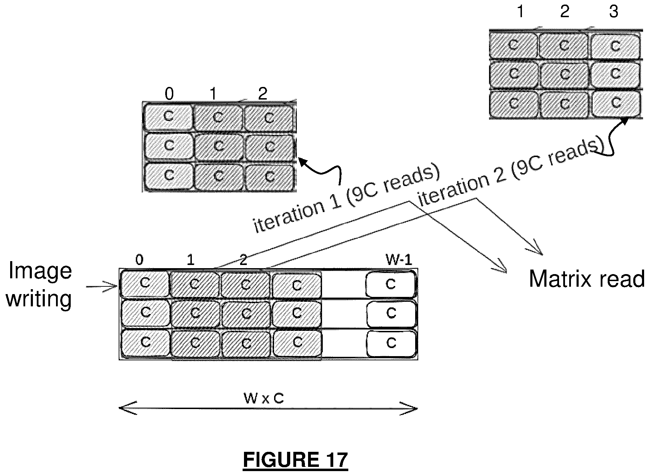

Figure 17 depicts a single convolutional patch extraction that may be performed by the serializer 3 from the input feature map $I < H, W, C >$ using a dual-port memory assembly 300 corresponding to a single dual-port memory. For example, to extract a convolution patch of size parameters $f_h = 3$ and $f_w = 3$, the memory device 300 used by the serializer 3 may be filled with 3 rows of the input feature map $I$, for example from row $I$ to $I + 3$. Each row of the input tensor $I$ is of size $W \times C$. The 3x3 convolutional patches at position $< I, 0 >$, $< I, 1 >$ up to $< I, w - 1 >$ may be read from a second port of the memory device 300. To avoid occurrence conflict, the serializer 3 may be configured to wait for $K$ to $K + 3$ ($K : K + 3$) rows being written, before starting reading the convolutional patches. Similarly, the write port has to wait until the read port has finished reading convolutional patches. More generally, to extract a convolution patch of size parameters $f_h$ and $f_w$, the memory device 300 used by the serializer 3 may be filled with $f_w$ rows of the input feature map $I$, for example from row $I$ to $I + f_w$. Each row of the input tensor $I$ is of size $W \times C$. The $f_w \times f_h$ convolutional patches at position $< I, 0 >$, $< I, 1 >$ up to $< I, w - 1 >$ may be read from a second port of the memory device 300. To avoid occurrence conflict, the serializer 3 may be configured to wait for $K$ to $K + f_w$ ($K : K + f_w$) rows being written, before starting reading the convolutional patches. Similarly, the write port has to wait until the read port has finished reading convolutional patches.

The extracted patches may be then fed to convolutional filtering device 90 implementing convolutional filters, as represented in figure 13. The serialized 1D vectors delivered by the serialize 3 are particularly suitable for enabling parallel processing convolutional filtering device 90 (for example by a plurality of processing layersets 2). In an application of the serializer 3 to a data filtering device implementing convolutional filters using a convolutional neural network, the convolutional filtering device 90 may receive the weights of the convolutional neural network to perform convolutional filtering using parallel processing.

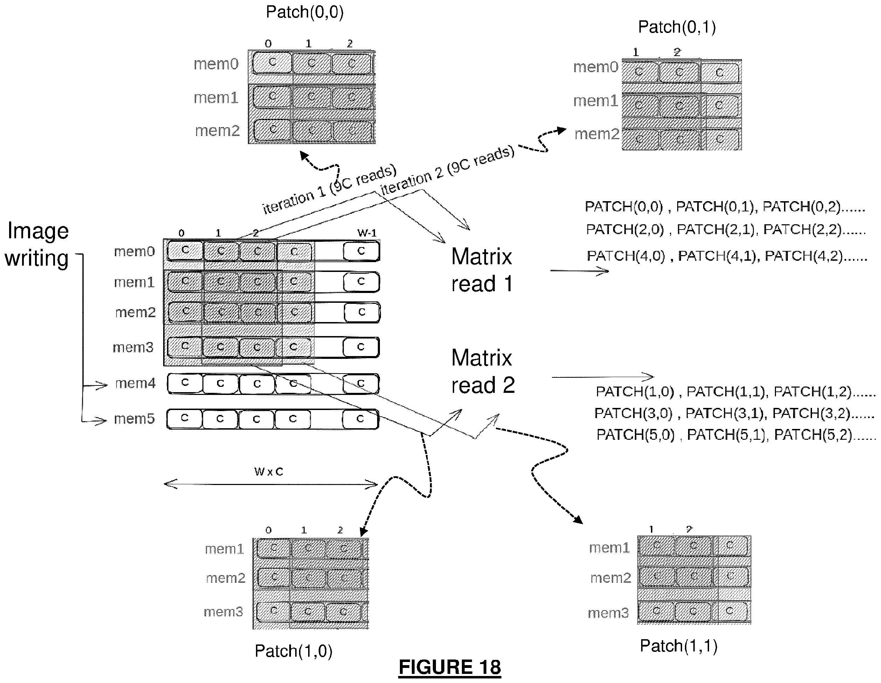

Figure 18 illustrates multiple patch extraction, according to some embodiments. In such embodiments, the serializer 3 is adapted to extract at least two patches in parallel. In the specific example of figure 18, the serializer 3 is adapted to extract two patches in parallel, one starting at even coordinates *patch*($2x,y$) and another starting at odd coordinates *patch*($2x + 1, y$). In this example, the serializer 3 is implemented using a dual-port memory assembly 300 constituted of 6 combined dual port memory banks 30 so that the dual-port memory assembly 300 forms a memory comprising one write port and two read ports. The incoming feature map $I < H, W, C >$ may be written through the single write port. The two read ports may be used to extract the convolutional patches simultaneously. To avoid conflicts, the dual-port memory assembly 300 may be configured so that the same memory bank is never read or written to at the same clock cycle.

The write/read operations occur in 3 phases as described in Table 3:

Table 3

|  | Phase 0 | Phase 1 | Phase 2 |
|---|---|---|---|
| Write | 4,5 | 0,1 | 2,3 |
| Read port A | 0,1,2 | 2,3,4 | 4,5,0 |
| Read port B | 1,2,3 | 3,4,5 | 5,0,1 |

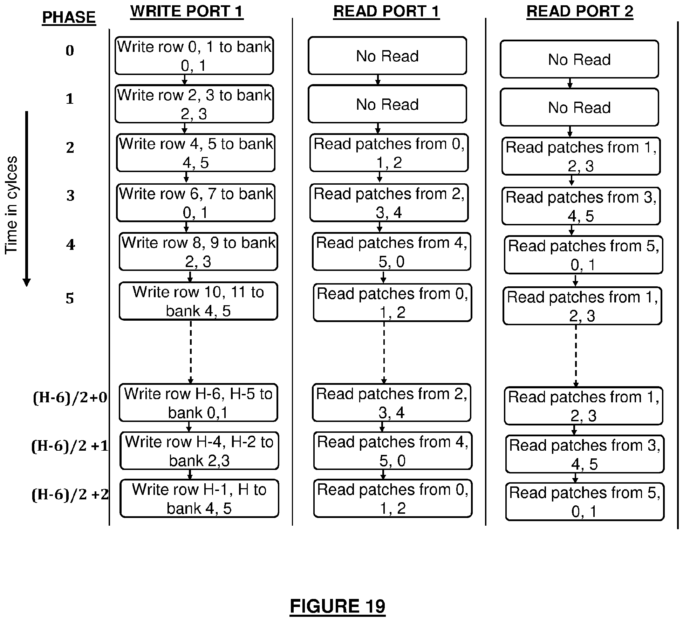

Figure 19 depicts the parallel read/write operations performed by the serializer 3, according to some embodiments. As illustrated by figure 19, the serializer 3 may be configured to perform read and write operations in parallel in a pipelined fashion, without any conflicts (related to read and write to the same memory bank) during one or more phases. Each phase has a duration of $w \times C \times f_h \times f_w$ clock cycles. For an input feature map tensor $I < H, W, C >$, $(H - 6)/2 + 3$ phases in total may be needed to generate all the necessary patches for a convolutional layer of the convolutional neural network used to implement convolutional filtering.

The serializer 3 is operable for performing write operations consisting in writing a number of rows from input feature map tensor $I$ to a number of banks of the memory device 300 using a writing port, while being operable for reading in parallel convolutional patches (extracting convolutional patches) from banks of the dual port memory assembly using at least one reading ports (two in the example of figure 16), the extracted convolutional patches being fed to the data filtering device 90 that can then process them in parallel, advantageously.

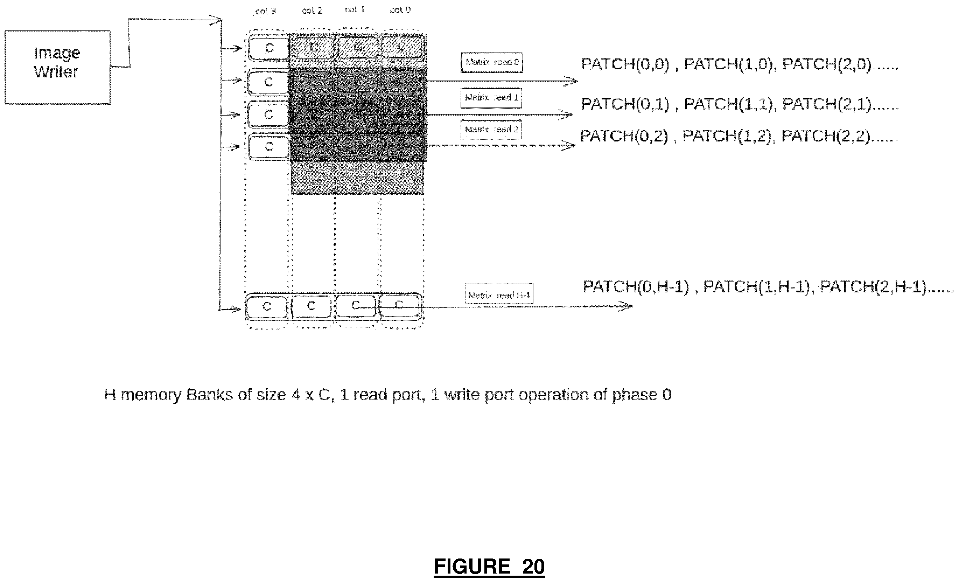

Figure 20 illustrates multiple patch extraction, according to embodiments where the input images are streamed in a column major order. In such embodiments, the serializer 3 is adapted to extract at least two patches in parallel. In the specific example of figure 20, the serializer 3 is adapted to extract $H$ patches in parallel, $H$ being the height of the image, starting at coordinates *patch* $(0, y)$ with y varying from 0 to $H - 1$. In this example, the serializer 3 is implemented using a dual-port memory assembly 300 constituted of $H$ combined dual port memory banks 30 so that the dual-port memory assembly 300 forms a memory comprising $H$ write ports and $H$ read ports. The column of incoming feature map $I < H, W, C >$ may be written through the $H$ write ports simultaneously in a column-major order. The $H$ read ports may be used to extract the convolutional patches $(i, y)$ simultaneously for $j$-th iteration (while index $i$ is used herein to describe the convolutional patches extraction, it will be understood that it is not linked to the preceding use of the notation $i$ when referring to the interconnected layersets 2).

To avoid conflicts, the dual-port memory assembly 300 may be configured so that the same memory bank is never read or written to at the same clock cycle.

The write/read operations occur in 4 phases as described in Table 4:

Table 4

|  | Phase 0 | Phase 1 | Phase 2 | Phase 4 |
|---|---|---|---|---|
| Write Col, (Rows 0.. H-1) | 3 | 0 | 1 | 2 |
| Port 0 Read col, (Rows 0,1,2) | 0,1,2 | 1,2,3 | 2,3,0 | 3,0,1 |
| Port 1 Read col (Rows 0,1,2) | 0,1,2 | 1,2,3 | 2,3,0 | 3,0,1 |
| Port H-1 read col (Rows H-3,H-2,H- | 0,1,2 | 1,2,3 | 2,3,0 | 3,0,1 |

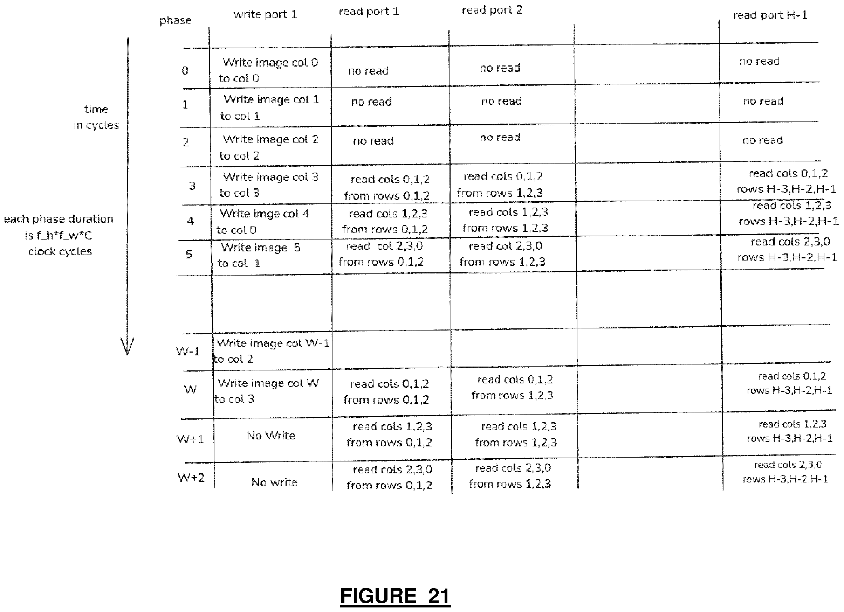

Figure 21 depicts the parallel read/write operations performed by the serializer 3 in embodiments using column major operation, according to some embodiments. A illustrated by figure 21, the serializer 3 may be configured to perform read and write operations in parallel in a pipelined fashion, without any conflicts (related to read and write to the same memory bank) during one or more phases. Each phase has a duration of $C \times f_h \times f_w$ clock cycles. For an input feature map tensor $I < H, W, C >$, $W$ phases in total may be needed to generate all the necessary patches for a convolutional layer of the convolutional neural network used to implement convolutional filtering.

The serializer 3 is operable for performing write operations consisting in writing a number of rows from input feature map tensor $I$ to a number of banks of the memory device 300 using a writing port, while being operable for reading in parallel convolutional patches (extracting convolutional patches) from banks of the dual port memory assembly using at least one reading ports (H in the example of figure 21), the extracted convolutional patches being fed to the data filtering device 90 that can then process them in parallel, advantageously.

Embodiments of the present disclosure can take the form of an embodiment containing hardware only or both hardware and software elements.

Furthermore, the methods described herein can be implemented by computer program instructions supplied to the processor of any type of computer to produce a machine with a processor that executes the instructions to implement the functions/acts specified herein. These computer program instructions may also be stored in a computer-readable medium that can direct a computer to function in a particular manner. To that end, the computer program instructions may be loaded onto a computer to cause the performance of a series of operational steps and thereby produce a computer implemented process such that the executed instructions provide processes for implementing the functions specified herein. In particular, the methods described herein may be implemented in a computer system.

It should be noted that the functions, acts, and/or operations specified in the flow charts, sequence diagrams, and/or block diagrams may be re-ordered, processed serially, and/or processed concurrently consistent with embodiments of the disclosure. Moreover, any of the flow charts, sequence diagrams, and/or block diagrams may include more or fewer blocks than those illustrated consistent with embodiments of the disclosure.

While embodiments of the disclosure have been illustrated by a description of various examples, and while these embodiments have been described in considerable detail, it is not the intent of the applicant to restrict or in any way limit the scope of the appended claims to such detail.

Additional advantages and modifications will readily appear to those skilled in the art. The disclosure in its broader aspects is therefore not limited to the specific details, representative methods, and illustrative examples shown and described.

## Claims

1. A serializer (3), wherein the serializer is configured to receive an input feature map represented by a Q-dimensional tensor and to convert the received input feature map into a series of 1D vectors, each corresponding to a convolutional patch, wherein the serializer comprises a memory device (300) comprising a plurality of ports and of memory banks adapted to store data words, said ports comprising a least a write port and at least two read ports,
wherein the serializer (3) is adapted to perform write operations consisting in writing a number of 1D vectors to a number of banks of said memory device (300) using the writing port, while being adapted for reading in parallel convolutional patches corresponding to stored 1D vectors from banks of the memory device (300) using said at least two reading ports, the extracted convolutional patches being fed to a convolutional filtering device (90) implementing convolutional filters.

2. The serializer of any preceding claim 1, wherein the serializer (3) is adapted to implement a number of phases to perform the write operations and the read operations, each phase comprising a write and/or read operation in the ports of the memory device.

3. The serializer of any preceding claim, wherein the tensor comprises at least three dimensions $H$, $W$ and $C$, $H$ being the height of the input feature map, $W$ being the width of the input feature map, and $C$ is the number of channels of the input feature map, and wherein a convolutional patch is defined by a position $< p, q >$ in the tensor $I$ and by two size parameter $f_h$ and $f_w$, a convolutional patch at position $< p, q >$, of size parameters $f_h$ and $f_w$, is defined as:

$$\bigcup_{i'=p}^{i'=p+f_w} \bigcup_{j'=q}^{j'=q+f_h} \bigcup_{j=0}^{j=C-1} I[i'][j'][k']$$

4. The serializer of claim 3, wherein each phase has a duration of $w \times C \times f_h \times f_w$ clock cycles.

5. The serializer of any preceding claim, wherein the memory device (300) comprises one or more dual port memories.

6. The serializer of claim 5, wherein the memory device (300) comprises a plurality of dual port memories (30), and wherein the memory device (300) comprises a number of R dual port memories, the memory device (300) having up to R write ports and up to R read ports.

7. The serializer according to any preceding claims, wherein the serializer is configured to store N data words, each having W bits, in the memory device (300).

8. The serializer according to any preceding claims, wherein each memory bank of the memory device (300) is only read or written in a given clock cycle.

9. The serializer according to any of the preceding claims, wherein the elements of the input tensor are streamed serially to the serializer in a row major order presenting one element of the input tensor at a time to the serializer, according to a row order.

10. The serializer according to any preceding claim 1 to 8, wherein the elements of the input tensor are streamed in parallel to the serializer in a column major order presenting a number of elements of the input tensor at a time to the serializer, according to a column order.

11. The serializer according to according to any preceding claim, wherein the input feature map corresponds to an image.

12. The serializer according to according to any preceding claim, wherein the input feature map corresponds to an audio file.

13. A convolutional filtering system comprising a serializer (3) according to any preceding claim and a convolutional filtering device (90) implementing convolutional filters, wherein the extracted convolutional patches are fed to the data filtering device (90), a convolutional filter having dimensions $fh \times fw$, where $f_h$ corresponds to the filter height and $f_w$ corresponds to the filter width.

14. The convolutional filtering system of claim 12, wherein the convolutional filtering device (90) comprises one or more layersets, each layerset comprising filter cores, each filter core implementing a number of convolutional filters.

15. The convolutional filtering system of any claim 13 and 14 wherein the convolutional filtering system is an accelerator using a convolutional neural network.

<u>1</u>

**FIGURE 1A**

**FIGURE 1B**

**FIGURE 2**

**FIGURE 3**

**1**

**22**

2200

2202-K  2202-*j*  2204-K  2204-*j*  2206-K  2206-*j*

Broadcasting Unit

Convolutional Lane K

Convolutional Lane j

Convolutional Lane 1

MaxPool

MaxPool

MaxPool

Merging Unit

Ouput Feature Stream

5

Weight Cache

Weight distributor

2201  2202-1  2204-1  2206-N  2207

**FIGURE 4**

**FIGURE 5**

**2202**

70

F[i] ....... F[3] F[2] F[1] F[0]

8 Bits

OUT (when i==N)

4 bits

Wg[0]
Wg[1]
Wg[2]
Wg[3]
.
.
.
Wg[i]

72

## FIGURE 6

**2202**

70

F[i] F[i] ....... F[3] F[3] F[2] F[2] F[1] F[1] F[0] F[0]

8 Bits

SHIFT for odd samples

OUT (when i==N)

4 bits

W[0][3:0]
W[0][7:4]
W[1][3:0]
W[1][7:4]
.
.
.
W[i][3:0]
W[i][7:4]

71

72

## FIGURE 7

Input Feature Stream

5

Weight
Cache

22

Filter Core

Output Feature Stream

**FIGURE 8**

Input

| $t=0$ | $t=1$ | $t=2$ | | $t=N_v-1$ | $t=N_v$ | $t=N_v+1$ | $t=N_v+2$ | | $t=2*N_v-1$ | $t=2*N_v$ |

$f(0,0)$  $f(0,1)$  $f(0,2)$  $f(0,N_v-1)$  $f(1,0)$  $f(1,1)$  $f(1,2)$  $f(1,N_v-1)$

K filter outputs

$OUT_{0,0}$

$OUT_{0,1}$

$OUT_{0,k-1}$

$OUT_{1,0}$

$OUT_{1,1}$

$OUT_{1,k-1}$

**FIGURE 9**

Input feature map reception — 800

Serialization — 801

802    803    804    805    Layerset $2_1$

Filter Core 22-$L_1$    Filter Core 22-$L_1$    Filter Core 22-$L_1$    Filter Core 22-$L_1$

806

Main interconnection

807    808    809    Layerset $2_2$

Filter Core 22-$L_2$    Filter Core 22-$L_2$    Filter Core 22-$L_2$

Layerset interconnection — 810

811    812    Layerset $2_3$

Filter Core 22-$L_3$    Filter Core 22-$L_3$

Layerset interconnection — 813

814    Layerset $2_4$

Filter Core 22-$L_4$

**<u>FIGURE 10</u>**

**FIGURE 11**

Unused core

```
                                                              900
   ┌─────────────────────────────────────────┐
   │        Loading input feature map         │
   └─────────────────────────────────────────┘
                        │
                        ▼                        901
   ┌─────────────────────────────────────────┐
   │        Performing sparsity encoding      │
   └─────────────────────────────────────────┘
                        │
                        ▼                        902
   ┌─────────────────────────────────────────┐
   │   Serializing the compressed input feature map  │
   └─────────────────────────────────────────┘
                        │
                        ▼                        903
   ┌─────────────────────────────────────────┐
   │  Broadcasting data streams to clusters and core │
   │                  filters                  │
   └─────────────────────────────────────────┘
                        ⋮
                        ◇

                        ◇                        904
   ┌ ─ ─ ─ ─ ─ ─ ─ ─ ─ ─ ─ ─ ─ ─ ─ ─ ─ ─ ─ ┐
   │ ┌ · · · · · · · · · · · · · · · · · · ┐ │
     Filter core
   │ │ ┌─────────────────────────────────┐ │ │
     │ │   Performing sparsity decoding  │ │
   │ │ └─────────────────────────────────┘ │ │
     │                │                      │
   │ │                ▼                      │ │   905
     │ ┌─────────────────────────────────┐ │
   │ │ │ Computing convolutions by processing non zero- │ │ │
     │ │   elements in the convolution lanes  │ │
   │ │ └─────────────────────────────────┘ │ │
     │                │                      │
   │ │                ▼                      │ │   906
     │ ┌─────────────────────────────────┐ │
   │ │ │ Performing Max Pooling in the max pooling blocks │ │ │
     │ └─────────────────────────────────┘ │
   │ │                │                      │ │
     │                ▼                          907
   │ │ ┌─────────────────────────────────┐ │ │
     │ │ Merging the outputs of the max pooling blocks │ │
   │ │ └─────────────────────────────────┘ │ │
     └ · · · · · · · · · · · · · · · · · · ┘
   │                  ◇                        │
                      ▼                            908
   │ ┌─────────────────────────────────────┐ │
     │  Combining the outputs of the core filters │
   │ └─────────────────────────────────────┘ │
   └ ─ ─ ─ ─ ─ ─ ─ ─ ─ ─ ─ ─ ─ ─ ─ ─ ─ ─ ─ ┘
                      ◇
                      ▼                            909
   ┌─────────────────────────────────────────┐
   │   Combining the outputs of the cluster   │
   └─────────────────────────────────────────┘
```

**FIGURE 12**

**100**

**FIGURE 13**

10

External
Input
memory

3

Writing
Ports

MEMORY DEVICE

300

90

Reading
Ports

Data
filtering
device

**FIGURE 14**

300

ADDR[LOG(N)-1:0]

N Words (W bits) dual port memory

ADDR[LOG(N)-1:0]

DATAIN[W-1:0]

DATAOUT[W-1:0]

**FIGURE 15**

300                          30-1

ADDR[LOG(M+N)-1:0]

N Words (W bits) dual port memory

ADDR[LOG(N)-1:0]

DATAIN[W-1:0]

DATAOUT[W-1:0]

30-2

M Words (W bits) dual port memory

ADDR[LOG(N)-1:0]

DATAIN[W-1:0]

DATAOUT[W-1:0]

**FIGURE 16**

**FIGURE 17**

FIGURE 18

| PHASE | **WRITE PORT 1** | **READ PORT 1** | **READ PORT 2** |
|---|---|---|---|
| 0 | Write row 0, 1 to bank 0, 1 | No Read | No Read |
| 1 | Write row 2, 3 to bank 2, 3 | No Read | No Read |
| 2 | Write row 4, 5 to bank 4, 5 | Read patches from 0, 1, 2 | Read patches from 1, 2, 3 |
| 3 | Write row 6, 7 to bank 0, 1 | Read patches from 2, 3, 4 | Read patches from 3, 4, 5 |
| 4 | Write row 8, 9 to bank 2, 3 | Read patches from 4, 5, 0 | Read patches from 5, 0, 1 |
| 5 | Write row 10, 11 to bank 4, 5 | Read patches from 0, 1, 2 | Read patches from 1, 2, 3 |
| $(H-6)/2+0$ | Write row H-6, H-5 to bank 0,1 | Read patches from 2, 3, 4 | Read patches from 1, 2, 3 |
| $(H-6)/2 +1$ | Write row H-4, H-2 to bank 2,3 | Read patches from 4, 5, 0 | Read patches from 3, 4, 5 |
| $(H-6)/2 +2$ | Write row H-1, H to bank 4, 5 | Read patches from 0, 1, 2 | Read patches from 5, 0, 1 |

Time in cylces

## FIGURE 19

EP 4 764 954 A1

col 3  col 2  col 1  col 0

Image
Writer

| C | C | C | C | Matrix read 0 | PATCH(0,0) , PATCH(1,0), PATCH(2,0)...... |

| C | C | C | C | Matrix read 1 | PATCH(0,1) , PATCH(1,1), PATCH(2,1)...... |

| C | C | C | C | Matrix read 2 | PATCH(0,2) , PATCH(1,2), PATCH(2,2)...... |

| C | C | C | C | Matrix read H-1 | PATCH(0,H-1) , PATCH(1,H-1), PATCH(2,H-1)...... |

H memory Banks of size 4 x C, 1 read port, 1 write port operation of phase 0

**FIGURE 20**

EP 4 764 954 A1

time
in cycles

each phase duration
is f_h*f_w*C
clock cycles

| phase | write port 1 | read port 1 | read port 2 | | read port H-1 |
|---|---|---|---|---|---|
| 0 | Write image col 0 to col 0 | no read | no read | | no read |
| 1 | Write image col 1 to col 1 | no read | no read | | no read |
| 2 | Write image col 2 to col 2 | no read | no read | | no read |
| 3 | Write image col 3 to col 3 | read cols 0,1,2 from rows 0,1,2 | read cols 0,1,2 from rows 1,2,3 | | read cols 0,1,2 rows H-3,H-2,H-1 |
| 4 | Write imge col 4 to col 0 | read cols 1,2,3 from rows 0,1,2 | read cols 1,2,3 from rows 1,2,3 | | read cols 1,2,3 rows H-3,H-2,H-1 |
| 5 | Write image 5 to col 1 | read col 2,3,0 from rows 0,1,2 | read col 2,3,0 from rows 1,2,3 | | read cols 2,3,0 rows H-3,H-2,H-1 |
| | | | | | |
| W-1 | Write image col W-1 to col 2 | | | | |
| W | Write image col W to col 3 | read cols 0,1,2 from rows 0,1,2 | read cols 0,1,2 from rows 1,2,3 | | read cols 0,1,2 rows H-3,H-2,H-1 |
| W+1 | No Write | read cols 1,2,3 from rows 0,1,2 | read cols 1,2,3 from rows 1,2,3 | | read cols 1,2,3 rows H-3,H-2,H-1 |
| W+2 | No write | read cols 2,3,0 from rows 0,1,2 | read cols 2,3,0 from rows 1,2,3 | | read cols 2,3,0 rows H-3,H-2,H-1 |

**FIGURE 21**

Europäisches
Patentamt
European
Patent Office
Office européen
des brevets

# EUROPEAN SEARCH REPORT

**Application Number**

EP 24 30 7282

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/418559 A1 (ROSSI MICHELE [IT] ET AL) 28 December 2023 (2023-12-28)<br>* Abstract *<br>* figures 1B,2,4-5,8,10-11 *<br>* [0018],[0037],[0042],[0046],[0049] *<br>----- | 1-15 | INV.<br>G06N3/063<br>G06N3/0464 |
| Y | KANG DUSEOK ET AL: "Multi-Bank On-Chip Memory Management Techniques for CNN Accelerators",<br>IEEE TRANSACTIONS ON COMPUTERS,<br>vol. 71, no. 5, 5 May 2022 (2022-05-05),<br>pages 1181-1193, XP093112042,<br>USA<br>ISSN: 0018-9340, DOI:<br>10.1109/TC.2021.3076987<br>* p1182 *<br>* figure 1 *<br>----- | 1-15 | |
| A | GONG CHUNYE ET AL: "An efficient image to column algorithm for convolutional neural networks*",<br>2021 INTERNATIONAL JOINT CONFERENCE ON NEURAL NETWORKS (IJCNN), IEEE,<br>18 July 2021 (2021-07-18), pages 1-8,<br>XP033974171,<br>DOI: 10.1109/IJCNN52387.2021.9533579<br>[retrieved on 2021-09-08]<br>* Title, Abstract *<br>----- | 1,10 | |

**TECHNICAL FIELDS SEARCHED (IPC)**

G06N
G06F

The present search report has been drawn up for all claims

| Place of search | Date of completion of the search | Examiner |
|---|---|---|
| The Hague | 30 May 2025 | Veynachter, Alexis |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 30 7282

This annex lists the patent family members relating to the patent documents cited in  the above-mentioned European search report.
The members are as contained in the European Patent Office EDP file on
The European Patent Office is in no way liable for these particulars which are merely given for the purpose of information.

30-05-2025

| Patent document cited in search report | Publication date | Patent family member(s) | | Publication date |
|---|---|---|---|---|
| US 2023418559 A1 | 28-12-2023 | CN | 117291248 A | 26-12-2023 |
| | | EP | 4296900 A1 | 27-12-2023 |
| | | US | 2023418559 A1 | 28-12-2023 |

For more details about this annex : see Official Journal of the European Patent Office, No. 12/82

## REFERENCES CITED IN THE DESCRIPTION

**Non-patent literature cited in the description**

- **LI, H.** ; **YUE, X.** ; **WANG, Z.** ; **CHAI, Z.** ; **WANG, W.** ; **TOMIYAMA, H.** ; **MENG, L.** Optimizing the deep neural networks by layer-wise refined pruning and the acceleration on FPGA. *Computational Intelligence and Neuroscience, 2022*, 2022

- **WU Z** ; **SHEN C** ; **VAN DEN HENGEL A**. Wider or deeper: Revisiting the resnet model for visual recognition. *Pattern Recognition*, 01 June 2019, vol. 90, 119-33

- Eyeriss: An energy efficient reconfigurable accelerator for deep convolutional neural networks. **Y.-H. CHEN** ; **T. KRISHNA** ; **J. EMER** ; **V. SZE**. 2016 IEEE International Solid-State Circuits Conference (ISSCC). IEEE, 2016, 262-263

- 14.6 A 1.42 TOPS/W deep convolutional neural network recognition processor for intelligent IoE systems. **J. SIM** ; **J.-S. PARK** ; **M. KIM** ; **D. BAE** ; **Y. CHOI** ; **L.-S. KIM**. 2016 IEEE International Solid-State Circuits Conference (ISSCC). IEEE, 2016, 264-265

- **B. MOONS** ; **M. VERHELST**. A 0.3-2.6 TOPS/W precision-scalable processor for real-time large-scale ConvNets. *IEEE Symposium on VLSI Circuits, Digest of Technical Papers*, 2016, 1-2

- **B. MOONS** ; **R. UYTTERHOEVEN** ; **W. DEHAENE** ; **M. VERHELST**. 14.5 Envision: A 0.26-to-10TOPS/W subwordparallel dynamicvoltage-accuracy-frequency-scalable Convolutional Neural Network processor in 28nm FDSOI. *2017 IEEE International Solid-State Circuits Conference (ISSCC)*, 2017, 246-247, http://ieeexplore.ieee.org/document/7870353

- An efficient hardware accelerator for sparse convolutional neural networks on FPGAs. **LU, L.** ; **XIE, J.** ; **HUANG, R.** ; **ZHANG, J.** ; **LIN, W.** ; **LIANG, Y.** 2019 IEEE 27th Annual International Symposium on Field-Programmable Custom Computing Machines (FCCM). IEEE., April 2019, 17-25

- **AIMAR A** ; **MOSTAFA H** ; **CALABRESE E** ; **RIOS-NAVARRO A** ; **TAPIADOR-MORALES R** ; **LUNGU IA** ; **MILDE MB** ; **CORRADI F** ; **LINARES-BARRANCO A** ; **LIU SC**. Nullhop: A flexible convolutional neural network accelerator based on sparse representations of feature maps. *IEEE transactions on neural networks and learning systems*, 26 July 2018, vol. 30 (3), 644-56

- Cambricon-X: An accelerator for sparse neural networks. **S. ZHANG** ; **Z. DU** ; **L. ZHANG** ; **H. LAN** ; **S. LIU** ; **L. LI** ; **Q. GUO** ; **T. CHEN** ; **Y. CHEN**. Proceedings of the Annual International Symposium on Micro-architecture, MICRO. IEEE, October 2016, 1-12